(19) Europäisches Patentamt
European Patent Office
Office européen des brevets

(11) **EP 3 648 012 B1**

(12) **EUROPEAN PATENT SPECIFICATION**

(45) Date of publication and mention
of the grant of the patent:
**27.11.2024 Bulletin 2024/48**

(51) International Patent Classification (IPC):
**G06N 3/048** (2023.01)      **G06N 3/09** (2023.01)
**G06N 3/0499** (2023.01)

(21) Application number: **18306413.8**

(22) Date of filing: **29.10.2018**

(52) Cooperative Patent Classification (CPC):
**G06N 3/048; G06N 3/09;** G06N 3/0499

(54) **MULTILEVEL ACTIVATION FUNCTION FOR DEEP NEURAL NETWORKS**

MEHRSTUFIGE AKTIVIERUNGSFUNKTION FÜR TIEFE NEURONALE NETZE

FONCTION D'ACTIVATION MULTINIVEAU POUR DES RÉSEAUX NEURONAUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.05.2020 Bulletin 2020/19**

(73) Proprietors:
• **Mitsubishi Electric R&D Centre Europe B.V.**
**1119 NS Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**

(72) Inventors:
• **CORLAY, Vincent**
**35708 Rennes cedex 7 (FR)**
• **BRUNEL, Loïc**
**35708 Rennes cedex 7 (FR)**
• **CIBLAT, Philippe**
**75634 Paris cedex (FR)**
• **BOUTROS, Joseph**
**75011 Paris (FR)**

(74) Representative: **Plasseraud IP**
**104 Rue de Richelieu**
**CS92104**
**75080 Paris Cedex 02 (FR)**

(56) References cited:
• **BOURAS D P ET AL: "Neural-net based receiver structures for single- and multi-amplitude signals in interference channels", NEURAL NETWORKS FOR SIGNAL PROCESSING Ý1994 IV. PROCEEDINGS OF THE 19 94 IEEE WORKSHOP ERMIONI, GREECE 6-8 SEPT. 1, NEW YORK, NY, USA,IEEE, 6 September 1994 (1994-09-06), pages 535 - 544, XP010125535, ISBN: 978-0-7803-2026-0, DOI: 10.1109/NNSP.1994.366012**
• **CORLAY VINCENT ET AL: "Multilevel MIMO Detection with Deep Learning", 2018 52ND ASILOMAR CONFERENCE ON SIGNALS, SYSTEMS, AND COMPUTERS, IEEE, 28 October 2018 (2018-10-28), pages 1805 - 1809, XP033521232, DOI: 10.1109/ACSSC.2018.8645519**
• **VINCENT CORLAY ET AL: "Neural Lattice Decoders", 2 August 2018 (2018-08-02), XP055583274, Retrieved from the Internet <URL:https://arxiv.org/pdf/1807.00592v2.pdf> [retrieved on 20190425]**

**Description**

The present invention relates to the decoding of data in a wireless communication system. BOURAS D P ET AL: "Neural-net based receiver structures for single- and multi-amplitude signals in interference channels",NEURAL NETWORKS FOR SIGNAL PROCESSING Ý1994 IV. PROCEEDINGS OF THE 1994 IEEE WORKSHOP ERMIONI, GREECE 6-8 SEPT. 1, NEW YORK, NY, USA,IEEE, 6 September 1994 (1994-09-06), pages 535-544, ,DOI: 10.1109/NNSP.1994.366012ISBN: 978-0-7803-2026-0 teaches neural networks-based techniques for signal processing.

It relates more precisely to artificial neural networks used for decoding of a received radio signal.

Traditionally, in a wireless communication system the transmitter and the receiver implement specific schemes with several components enabling to process the radio signal transmitting the data.

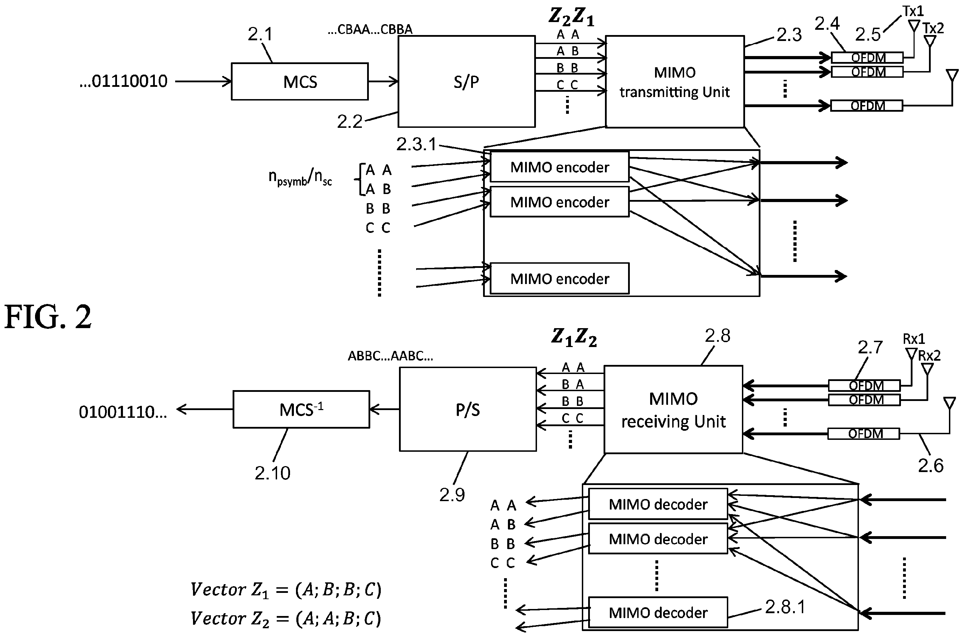

In figure 2 it is shown an example of a transmitter's scheme (referred to as transmitter scheme) and the corresponding receiver's scheme (referred to as receiver scheme) in a wireless communication system. The encoding/decoding of the radio signal in such system (transmitter and receiver) is crucial, a tradeoff between the rate of the transmission, the robustness of the transmission leading to decoding errors and the complexity of the receiver must be found.

However, recently artificial neural networks (ANN) have been used to replace components of the receiver, enabling to perform a more efficient decoding.

Nevertheless, efficient and accurate ANNs are still complex and therefore require an important amount of computing resources (CPU, GPU or dedicated hardware), which in the context of a wireless communication is a strong drawback.

The present invention aims at improving the situation.

To that end, the invention relates to a method according to claim 1, to a computer program product according to claim 10 and to a device according to claim 11. Preferred embodiments are defined by the dependent claims.

Data to be transmitted to a receiver is processed by a transmitter which applies to the data a scheme including an encoder E (for example: MIMO encoders, Lattice encoder) the scheme may also comprise other encoders and processing modules such as a MCS module and/or a Digital Analog Converter and/or a serial to parallel converter, etc. At the receiver side the radio signal received is decoded through a receiver scheme adapted to decode the radio signal processed by the scheme of the transmitter. That is, the receiver scheme may comprise modules corresponding to the modules of the transmitter scheme (for example an Analog Digital Converter, a MIMO decoders...). The symbols outputted by the encoder E and processed by the modules of the transmitter scheme following the encoder E are transmitted through the radio communication channel (radio channel) to the receiver. The receiver applies the modules of the inverse scheme to that of the transmitter scheme, and obtains the $M_0$ symbols $X_1^0, ..., X_{M_0}^0$. These symbols represent at the receiver side the symbols outputted by the encoder E. These $M_0$ symbols are inputted in an artificial neural network decoder which decodes them and retrieves the symbols inputted in the encoder E.

At least one of the activation functions of the artificial neural network decoder is a multiple level activation function. A multiple level activation function is an activation function that enables to discriminate between more than two classes (at least three) and therefore consider more than two outputs (or levels of output) (at least 3), that is, at least three outputs (or levels of output).

The new telecommunication standards (for example, LTE, NR) implement encoders and decoders which process and produce an increasing number of symbols (For example, 256 QAM, any Lattice encoder, especially high spectral efficiency lattice-based encoder). That is, many values or symbols can be taken by the outputs and/or inputs of those decoders and encoders. Therefore, when replacing such decoder by an artificial neural network (ANN) decoder, the ANN decoder will face a high complexity on its outputs and/or inputs. This complexity does not affect only the inputs and outputs of the ANN system but propagates through the hidden layers of the ANN system. Therefore, the neurons (also referred as nodes) of the output layer as the neurons of the hidden layers may carry out the solving of multiclass classification problems, that is, to classify an element according to more than two classes. In this context and since a multiple level activation function (MLAF) enables multiclass classification at the output of a unique node/neuron, several nodes implementing regular activation functions (at the most 2 levels activation functions) may be replaced by one node implementing a MLAF. Therefore, an ANN decoder that uses MLAFs will need less neurons to decode the $M_0$ symbols. Therefore, by using less neurons, the complexity of the decoder decreases and less computing resources (CPU, GPU or dedicated hardware) are needed to decode the $M_0$ symbols.

In addition, when the number of layers and nodes is fixed, implementing MALFs in the nodes of the ANN system enables to enhance its accuracy.

By a multiple level activation function, it is understood an activation function that enables to consider strictly more than two levels of output. That is, an activation function that enables to discriminate input values in strictly more than two groups or classes. Therefore, a multiple level activation function of K levels with K strictly superior to 2, outputs K different groups of values, each group of values being easily discriminated. Advantageously, the inverse images of these groups under $f$ (where $f$ is the MLAF) are disjoint.

Advantageously, this discrimination property may be obtained with functions that exhibit at least three nearly constant regions. In other words, two inputs $x_1$ and $x_2$ are in the same group if $|f(x_2) - f(x_1)|$ is negligible compared to $|x_2 - x_1|$ or at least lower than $\varepsilon|x_2 - x_1|$ with $\varepsilon$ strictly smaller than 1, for example $\varepsilon$ may be equal to ½, 1/5, 1/10 or 1/50.

Advantageously, this discrimination property may be obtained with functions for which two inputs $x_1$ and $x_2$ are in the same group if $|f(x_2) - f(x_1)|$ is negligible compared to $|f(x_2) - f(x_3)|$ or at least lower than $\varepsilon|f(x_2) - f(x_3)|$ with $x_2$ and $x_3$ being in two different groups and with $\varepsilon$ strictly smaller than 1, for example $\varepsilon$ may be equal to ½, 1/5, 1/10 or 1/50.

By activation function it is understood a function that defines the output of a node (neuron) given its input. Activation functions share specific properties. For the sake of simplicity, when not specified as MLAF, activation function refers to regular activation function which is at the most 2 levels activation function. Regular activation functions are the activation functions known, by the person skilled in the art, to be used in the ANN system.

By symbols it is understood a real number belonging to a discrete set of numbers. The skilled person understands that complex symbols may be considered as two real symbols and therefore that the invention may be applied in the context of complex symbols.

By wireless communication medium it is understood a wireless communication system. That is, a system which enables transmitting data between a transmitter and a receiver using wireless technologies, generally radio waves, but can also be implemented with other wireless technologies, such as light, magnetic, or electric fields or the use of sound.

By ANN decoder it is understood a decoder, that is, a module of the receiver scheme that comprises at least one ANN system. The ANN decoder may comprise several ANN systems. For example, when the ANN decoder replaces MIMO decoders, an ANN system for each MIMO decoder may be implemented in the ANN decoder. For the sake of simplicity only an ANN decoder with a unique ANN system is described in the followings. Thus, the inputs and outputs of the ANN system coincide with the inputs and outputs of the ANN decoder.

By received symbols representing symbols encoded by an encoder E of the transmitter it is understood the symbols resulting from the processing of the symbols outputted by the encoder E by the transmitter according to the transmitter scheme and which have been received by the receiver. These received symbols may have been processed at the receiver side before being inputted in the ANN decoder. Indeed, the ANN decoder may not replace all the modules of the receiver scheme. For example, the ANN decoder may replace only a MIMO decoder (or several MIMO decoders) and therefore several modules are applied before inputting the symbols in the ANN decoder.

The decoder or more specifically the artificial neural network system can be defined as a function $F$ which is defined by N sets of functions $\mathrm{F}_1^i, \dots, \mathrm{F}_{M_i}^i$, with i from 1 to N,

$$F_m^i\left(\mathrm{X}_1^{i-1}, \dots, \mathrm{X}_{M_{i-1}}^{i-1}\right) = f_m^i\left(\sum_{k=1}^{M_{i-1}} w_{k,m}^{i-1} \times X_k^{i-1} + \beta_m^i\right),$$

with

$$F\left(\mathrm{X}_1^0, \dots, \mathrm{X}_{M_0}^0\right) = \left[F_1^N\left(X_1^{N-1}, \dots, X_{M_{N-1}}^{N-1}\right), \dots, F_{M_N}^N\left(X_1^{N-1}, \dots, X_{M_{N-1}}^{N-1}\right)\right]$$

, where, $\mathrm{X}_m^{i-1}$ are respectively the outputs of the functions $\mathrm{F}_m^{i-1}$, $\mathrm{X}_m^{i-1} = \mathrm{F}_m^{i-1}(\mathrm{X}_1^{i-2}, \dots, \mathrm{X}_{M_{i-1}}^{i-2})$ of the (i-1)-th set, each $f_m^i$ is either an artificial neural network activation function or an identity function, at least one of the $f_m^i$ is not an identity function and $w_1^{i-1}, \dots, w_{M_{i-1}}^{i-1}, \beta_m^i$ are real number parameters.

The set of functions $\mathrm{F}_1^i, \dots, \mathrm{F}_{M_i}^i$ among the N sets represents the i-th layer of the ANN system/decoder. Therefore, the ANN system is a N-layer ANN system. Each function $\mathrm{F}_m^i$ corresponds to a node of the i-th layer.

The parameters $w_{1,m}^{i-1}, \dots, w_{M_{i-1},m}^{i-1}, \beta_m^i$ for m from 1 to $M_i$ and i from 1 to N are real numbers that may be equal to zero, positive or negative.

The artificial neural network system is trained on a training set of vectors $\hat{Z}^j$, each vector $\hat{Z}^j$ being compared with the output of the artificial neural network system when applied to a vector $\hat{X}^j$, with $\hat{X}^j = \hat{X}^j = (\widehat{X}_1^{0,j}, \dots, \widehat{X}_{M_0}^{0,j})$, the vectors $\hat{X}^j$ being obtained by applying respectively to the vectors $\hat{Z}^j$ successively a first transformation representing the encoder E and a second transformation representing at least:

- a part of a transmitting scheme of the transmitter, said part of the transmitting scheme following the encoder E, and

- a radio communication channel.

By training the ANN system it is understood to apply a supervised learning method. For example, a backpropagation method can be implemented, using a training set of T vectors $\overset{\wedge}{Z^j}$, with j from 1 to T, and the corresponding set of vectors $\overset{\wedge}{X^j}$, each vector $\overset{\wedge}{X^j}$ being obtained by applying transformations representing at least the transmitter scheme from the input of the encoder E to the emission of the transmission signal and a radio communication channel to the training set of vectors $\overset{\wedge}{Z^j}$. The second transformation may also represent the scheme applied at the receiver side from the reception of the radio signal to the input of the ANN system.

The output of the ANN system when applying the ANN system to the vector $\overset{\wedge}{X^j}$, is compared with the vector $\overset{\wedge}{Z^j}$, which is the ideal, or at least suitable, response of the ANN system regarding the vector $\overset{\wedge}{X^j}$ (that is the input of the encoder E which results in the vector $\overset{\wedge}{X^j}$). The parameters of the ANN system are modified to reduce the overall gap between respectively the ideal responses and the actual responses of the ANN system regarding the vectors $\overset{\wedge}{X^j}$.

Advantageously, more than one vector $\overset{\wedge}{X^j}$ may be obtained as previously described for each vector $\overset{\wedge}{Z^j}$. Indeed, there exist many possible transformations representing part of the transmitter scheme, the radio communication channel and part of the receiver scheme. For example, several transformations may represent a MIMO encoder, one for each pre-coding matrix. Several transformations may represent the radio communication channel, one transformation for each channel matrix and noise vector that can represent the radio communication channel. Therefore, each vector $\overset{\wedge}{Z^j}$ can be associated with a group of vectors $\overset{\wedge}{X^{j,T}}$, with $T$ from 1 to S. Two $\overset{\wedge}{X^{j,T}}$ and $\overset{\wedge}{X^{j,T'}}$ are obtained with different transformations $T$ and $T'$ applied to the same vector $\overset{\wedge}{Z^j}$, each representing the same components of the transmitter and receiver schemes. However, each transformation may represent a different configuration of these components and/or a different radio communication channel. For the sake of simplicity, in the following only one vector $\overset{\wedge}{X^j}$ is described for each vector $\overset{\wedge}{Z^j}$.

Mathematically, said parameters $w_1^{i-1}, \dots, w_{M_{i-1}}^{i-1}, \beta_m^i$, with i from 1 to N are computed to minimize a distance (also called a cost function) between respectively outputs $F(\widehat{X}_1^{0,j}, \dots, \widehat{X}_{M_0}^{0,j})$ of the decoder and vectors $\overset{\wedge}{Z^j}$ of a training set of vectors, with $\overset{\wedge}{Z^j} = (\widehat{Z}_1^j, \dots, \widehat{Z}_{M_N}^j)$. This optimization of the parameters is done to minimize the distance $d(\overset{\wedge}{Z^j}, F(\overset{\wedge}{X^j}))$ on all the training set. For example, by minimizing $\sum_{j=1}^T d(\widehat{Z}^j, F(\widehat{X}^j))$ or $\sum_{j=1}^T a_j \cdot d(\widehat{Z}^j, F(\widehat{X}^j))$, with $\alpha_j$ a strictly positive real number. The distance $d$ may be for example the Euclidean distance, square Euclidean distance or the cross-entropy.

In the context of ANN systems replacing decoders in receiver schemes, since the complexity of these ANN systems decreases when implementing at least one MLAF, the training of such ANN systems requires less computing resources (CPU, GPU or dedicated hardware).

By a transformation representing a scheme and/or a radio communication channel it is understood a mathematical representation of the scheme and/or of the radio communication channel. For example, the radio communication channel may be represented by a channel matrix and a noise vector.

By part of the transmitting/receiving scheme it is understood one or several components (also referred as modules) of the transmitting/receiving scheme that are successively applied to produce/process the radio signal.

The radio communication channel can be generalized with any wireless communication channel that can for example be mathematically represented or encountered in a given environment. Therefore, in the case of a wireless communication system based on other wireless technologies other representations of the communication channel will be made.

The multiple level activation function may be defined as:

$$f_{K,B_1,\dots,B_{K-1},A,\tau_1,\dots,\tau_{K-1}}(x) = \sum_{l=1}^{K-1} B_l f_l(x - \tau_l) + A$$

with each $f_l$ being a regular activation function (to which we refer as activation function when not specified that it is a MLAF, that is at the most a 2 levels activation function),
with $\tau_l$ being real numbers, and if $l \neq l' \Rightarrow \tau_l \neq \tau_{l'}$,
with A and the $B_l$ being real numbers,
and K a positive integer greater than or equal to 3.

This definition enables to easily produce MLAFs adapted to each or at least several nodes of the ANN system, when implementing several MLAFs in an ANN system. Therefore, depending on the structure and the computing carried out by the ANN system (resulting from the problem solved by the ANN system) the MLAFs can be adapted. In addition, the parameters $K, B_1, ..., B_{K-1}, A, \tau_1, ..., \tau_{K-1}$ can be set previously to the training of the ANN system or they can be considered as the parameters of the ANN system which are modified to reduce the overall gap between respectively the ideal responses and the actual responses of the ANN system regarding the vectors $\hat{X}_j$. Each of the MLAF can be parametrized differently. The activation functions $f_l$ may be the same or different. However, the activation functions $f_l$ used are activation functions that enable to discriminate inputs values in two groups or classes (that is at the most 2 levels activation functions), for example Logistic function, Heaviside step function, Hyperbolic tangent function (TanH), arctangent function, Softsign function" Rectified linear unit function (ReLu), Leaky rectified linear unit function (Leaky ReLU), Parameteric rectified linear unit function (PReLU), Randomized leaky rectified linear unit function (RReLU), Exponential linear unit function (ELU), Scaled exponential linear unit function (SELU), SoftPlus function, Sigmoid-weighted linear unit function (SiLU), Sigmoid function, Maxout function.

K is the number of levels discriminated. The MLAF $f_{K, B_1, ..., BK-1, A, \tau_1, ..., \tau_{K-1}}(x)$ is therefore a K-levels MLAF.

All the following multiple level activation functions may be defined as a function $f_{K, B_1, ..., BK-1, A, \tau_1, ..., \tau_{K-1}}(x)$ with potentially different parameters.

The inputs of the encoder E are connected to the outputs of a Modulation encoder.

Therefore, the ANN decoder outputs sequences of symbols as defined by the modulation scheme used. The ANN decoder aims at retrieving the symbols to which are applied the encoder E, the following scheme of the transmitter, and which are received by the receiver and inputted in the ANN decoder. Modules of the transmitter may be applied to the received signal to obtain the $M_0$ symbols inputted in the ANN decoder.

The modulation decoder may be a modulation and coding scheme decoder. However, the modulation scheme applied by the decoder can be of any sort, for example the symbols of the modulation scheme can be complex (QPSK, QAM) or real (PAM). Optionally, a P/S module may be implemented between the ANN decoder and the Modulation decoder (also referred to as a demodulator).

At least one of the functions $f_m^N$ with m from 1 to $M_N$, is a multiple level activation function.

In this case at least one of the activation functions on the output layer of the ANN system, that is, one of the function $f_m^N$, with m from 1 to $M_N$ is a multiple level activation function. The outputs of the ANN system correspond to modulation symbols, which are then inputted in the Modulation decoder. Since in the modulation schemes several symbols are used, more than 2 real symbols (except for example in BPSK), using multiple level activation function on the output layer of the ANN system enables to use less nodes on the output layer to output all the possible symbols of the modulation scheme. Indeed, by using a MLAF the output of which may take K distinctive values (K greater than 2) enables to distinguish K different symbols at the output of the MLAF. For example, if the modulation scheme comprises K symbols, then using a K-level MLAF on the output layer of the ANN system enables to represent all the different symbols of the modulation scheme at the output of a unique activation function. Therefore, it enables to reduce the number of nodes needed to output values enabling to represent all the symbols of the modulation scheme.

More specifically, when symbols of the modulation scheme used by the Modulation encoder are each defined by P coordinates $(q_1; ...; q_P)$, it is advantageous to use on the output layer of the ANN system at least P' functions $(f_{m_1}^N, ..., f_{m_{P'}}^N)$ among the functions $f_m^N$, with m from 1 to $M_N$, which respectively output values of P' coordinates among the P coordinates $(q_1; ...; q_P)$ and wherein each $f_{m_k}^N$ is a $K_k$-level activation function, where $K_k$ is equal to the number of values that can take the k-th coordinate among the P' coordinates of the symbols of the modulation type.

By modulation type it is understood a modulation scheme.

Therefore, the outputs of a number of MLAFs equal to the dimension of the modulation scheme, that is, for example the dimension of the constellation diagram, may enable to represent all the symbols of the modulation scheme.

All the functions $f_m^N$ with m from 1 to $M_N$, are multiple level activation functions.

As previously mentioned, the MLAFs of the output layer of the ANN system may be of the type $f_{K, B_1, ..., B_{K-1}, A, \tau_1, ..., \tau_{K-1}}(x) = \sum_{l=1}^{K-1} B_l f_l(x - \tau_l) + A$. The parameters of these MLAFs may be different.

According to an aspect of the invention, the encoder E comprises a Lattice encoder, and the inputs of the Lattice encoder are the inputs of the encoder E.

Therefore, the ANN decoder replaces at least a Lattice decoder.

By Lattice encoder it is understood an encoder which outputs an n-tuple of real numbers $\sum_{i=1}^{n} z_i\, e_i \in \mathbb{R}^n$ when at its input it is inputted an n-tuple of integers $(z_1,..., z_n) \in \mathbb{Z}^n$, with $(e_1,...,e_n)$ a basis of $\mathbb{R}^n$, that is $e_i \in \mathbb{R}^n$ and the $(e_1,...,e_n)$ are linearly independent. That is, for each n-tuple of integers $(z_1, ..., z_n) \in \mathbb{Z}^n$ the encoder outputs a unique point or element of a lattice in $\mathbb{R}^n$.

Therefore, the ANN decoder outputs n-tuple of integers $(z_1, ..., z_n) \in \mathbb{Z}^n$.

The input of the Lattice encoder may be a Pulse-amplitude modulation (PAM) encoder which outputs integers. For example, a 4-level PAM will input in the Lattice encoder integers among 0, 1, 2 and 3.

According to an aspect of the invention, at least one of the functions $f_m^i$ with m from 1 to $M_i$ and i from 1 to N-1 is a multiple level activation function.

As previously mentioned, the MLAFs of the hidden layers of the ANN system may be of the type $f_{K,B_1,...,B_{K-1},A,\tau_1,...,\tau_{K-1}}(x) = \sum_{l=1}^{K-1} B_l\, f_l(x - \tau_l) + A$. The parameters of these MLAFs may be different.

This enables to reduce the numbers of nodes needed in the ANN decoder and thus reduces the complexity of the decoder which therefore requires less computing resources (CPU, GPU or dedicated hardware) to decode the $M_0$ symbols.

According to an aspect of the invention, the encoder E comprises a MIMO encoder.

Therefore, the ANN decoder may replace at least one or several MIMO decoders for example by implementing one ANN system for each MIMO decoder or one ANN system for all the MIMO decoders. In addition, using the ANN decoder to replace at least a MIMO decoder and another module enables to optimize the use of the ANN decoder. Indeed, it is possible to train an ANN system to replace MIMO decoders and another module, for example a lattice decoder, without modifying the number of layers which would have been used in a ANN system replacing only a lattice decoder or at least adding to that ANN system a number of layers smaller than the number of layers necessary for an ANN system to replace only a MIMO decoder. Even though the number of layers is reduced, the number of nodes per layer may increase or the accuracy of the ANN system may be reduced, therefore in such context it is possible to replace groups of nodes by MLAFs enabling to reduce or at least to maintain the level of complexity of the ANN system when the ANN system replaces more than one module.

The present invention is illustrated by way of example, and not by way of limitation, in the figures of the accompanying drawings, in which like reference numerals refer to similar elements and in which:

- Figure 1 illustrates a transmitter and receiver.
- Figure 2 schematizes a block diagram of a classical MIMO transmitter and a classical MIMO receiver.
- Figure 3 schematizes a block diagram of a MIMO transmitter and a MIMO receiver respectively implementing a Lattice encoder and a Lattice decoder.
- Figure 4 illustrates a two-dimensional Lattice.
- Figure 5 schematizes an ANN system.
- Figure 6 schematizes a block diagram of a classical MIMO transmitter and a receiver implementing a ANN decoder.
- Figure 7 schematizes a block diagram of a MIMO transmitter implementing a Lattice encoder and a MIMO receiver implementing an ANN-Lattice decoder.
- Figure 8 illustrates a MLAF.
- Figure 9 illustrates a flowchart representing the decoding of a radio signal.

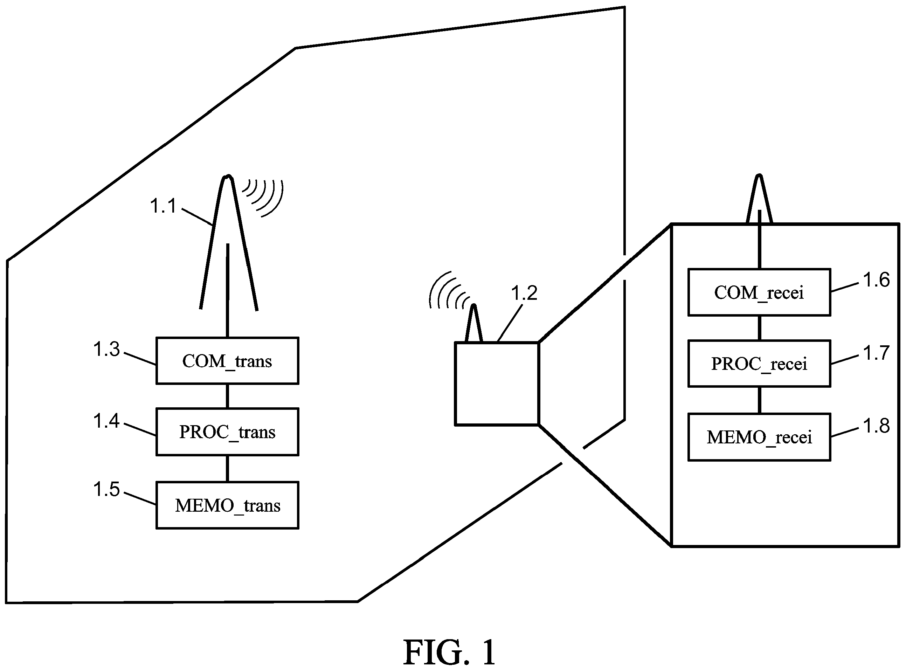

Referring to Figure 1, it is showed a transmitter 1.1 transmitting a radio signal to a receiver 1.2. The receiver 1.2 is in the cell coverage of the transmitter 1.1. This transmission may be an OFDM based transmission. In this example the receiver 1.2 is a mobile terminal and the transmitter 1.1 is a fixed station which in the context of LTE is a base station. The transmitter 1.1 can as well be the mobile terminal and the receiver 1.2 a fixed station. Both, the transmitter 1.1 and the receiver 1.2 may be mobile terminals.

The transmitter 1.1 comprises one communication module (COM_trans) 1.3, one processing module (PROC_trans) 1.4 and a memory unit (MEMO _trans) 1.5. The MEMO_trans 1.5 comprises a non-volatile unit which retrieves the computer program and a volatile unit which retrieves the parameters of the transmitter scheme (Modulation scheme applied, etc.). The PROC_trans 1.4 is configured to process the data to transmit according to the transmitter scheme including the encoder E. The COM trans 1.3 is configured to transmit to the receiver 1.2 the radio signal. The processing of the data intended to be transmitted may also be realized by the COM_trans 1.3 rather than by the PROC_trans 1.4, in that case the PROC_trans 1.4 configures the COM_trans 1.3 to perform this processing. Indeed, the processing may be performed by electronic circuits dedicated to the processing of the data according to the transmitter scheme, or the processing may be performed by processors which process the data according to the transmitter scheme. The invention is not limited to such implementations and encompasses any combination of electronic and computing processing to process the data according to the transmitter scheme.

The receiver 1.2 comprises one communication module (COM_recei) 1.6, one processing module (PROC_recei) 1.7 and a memory unit (MEMO_recei) 1.8. The MEMO_recei 1.8 comprises a non-volatile unit which retrieves the computer program and a volatile unit which retrieves the parameters of the receiver scheme (Demodulation scheme applied, parameters of the ANN decoder obtained during the training, etc.). The PROC_recei 1.7 is configured to process the radio signal received from the transmitter according to the receiver scheme including the ANN decoder which has been previously trained. The COM_recei 1.6 is configured to receive from the transmitter the radio signal. The processing of the radio signal to retrieve the data may also be realized by the COM_recei 1.6 rather than by the PROC_recei 1.5, in that case the PROC_recei 1.5 configures the COM_recei 1.6 to perform this processing. Indeed, the processing may be performed by electronic circuits dedicated to the processing of the radio signal according to the transmitter scheme, or the processing may be performed by processors which process the radio signal according to the transmitter scheme. The invention is not limited to such implementations and encompasses any combination of electronic and computing processing to process the radio signal according to the transmitter scheme. When the ANN decoder is implemented by an electronic circuit, this electronic circuit may be a programmable logic device, which enables to adapt the ANN system according to training parameters defined during the training of the ANN system.

Referring to Figure 2, it is showed a block diagram of a classical MIMO transmitter and a classical MIMO receiver.

The radio signal is obtained by processing data in the transmitter scheme. That is, by applying to a binary sequence, which represents the data to be transmitted, a modulation and coding scheme (MCS) encoder 2.1. The MCS encoder 2.1 outputs a sequence of symbols which are taken from a specific digital modulation scheme, for example, a QAM for which each symbol is considered as two real symbols in the following. These symbols are represented in figure 2 by letters (...CBAA...CBBA). A serial to parallel module (S/P) 2.2 is then applied to the sequence of symbols to output $n_{psym}$ parallel symbols, 4 parallel symbols in the example of figure 2. These $n_{psym}$ parallel symbols ($Z_1$ or $Z_2$ in figure 2) are then inputted in the MIMO transmitting unit 2.3 which inputs in each of the $n_{OFDM/Tx}$ OFDM encoders 2.4 $n_{sc}$ parallel symbols (where $n_{sc}$ is the number of subcarriers used to carry symbols, also called useful subcarriers, that is non null subcarriers). The symbols outputted by the MIMO transmitting unit 2.3 are obtained according to pre-coding matrices that configures the MIMO transmitting unit 2.3. More specifically, the $n_{psym}$ parallel symbols are respectively inputted by groups of $n_{psymb}/n_{sc}$ parallel symbols in each of the $n_{sc}$ MIMO encoders 2.3.1. Each MIMO encoder 2.3.1, which is parameterized according to a pre-coding matrix, outputs $n_{OFDM/Tx}$ symbols which are respectively inputted on the same subcarrier in each of the $n_{OFDM/Tx}$ OFDM encoders 2.4. Therefore, each OFDM encoder 2.4 receives one symbol from each MIMO encoder 2.3.1 (i.e. $n_{sc}$ symbols from $n_{sc}$ different MIMO encoders, one for each subcarrier), that is each OFDM encoder 2.4 receives $n_{sc}$ parallel symbols from the MIMO transmitting unit 2.3.

Each OFDM encoder 2.4 processes the $n_{sc}$ parallel symbols received at its input by applying an IFFT (Inverse fast Fourier transform) module and DACs (Digital Analog Converter). The output of each OFDM encoder 2.4 is emitted on one antenna Tx 2.5.

The radio signal is received by the receiver 1.2 on each of its $n_{OFDM/Rx}$ antennas Rx 2.6. To each signal received is applied an OFDM decoder 2.7. Each of the OFDM decoders 2.7 of the receiver 1.2 outputs $n_{sc}$ parallel symbols which are inputted in the MIMO receiving unit 2.8. The MIMO receiving unit 2.8 decodes the $n_{OFDM/Rx}$ groups of $n_{sc}$ symbols respectively outputted by the OFDM decoders 2.7 according to pre-coding matrix by which it has been configured. The MIMO receiving unit 2.8 outputs $n_{psym}$ symbols to which are applied successively a parallel to serial module 2.9 and a MCS decoder 2.10, that is, a demodulator and a decoding module, or simply a demodulator. More specifically, each OFDM decoder 2.7 inputs $n_{sc}$ parallel symbols respectively in the $n_{sc}$ MIMO decoders 2.8.1, that is one symbol in each MIMO decoder 2.8.1. Each inputted symbol in the MIMO receiving unit 2.8 is inputted in one of the $n_{sc}$ MIMO decoders 2.8.1. Each MIMO decoder 2.8.1 receives from each OFDM decoder 2.7 a symbol from the same subcarrier and outputs $n_{psymb}/n_{sc}$ symbols according to a pre-coding matrix to which it has been configured. That is, the $n_{sc}$ MIMO decoders 2.8.1. output $n_{psymb}$ parallel symbols.

If the radio channel did not affect too much the radio signal and the noise of the different systems (transmitter 1.1 and receiver 1.2) is limited, the binary sequences emitted by the transmitter 1.1 are retrieved at the receiver 1.2 side.

Each OFDM decoder 2.7 applies on the signal received by their corresponding antenna Rx 2.6 ADCs (Analog Digital Converter) and a FFT (Fast Fourier transform) module which outputs $n_{sc}$ symbols.

In the case of the invention which implements such scheme, antenna ports implementing another scheme than an Orthogonal frequency-division multiplexing (OFDM) scheme may be implemented.

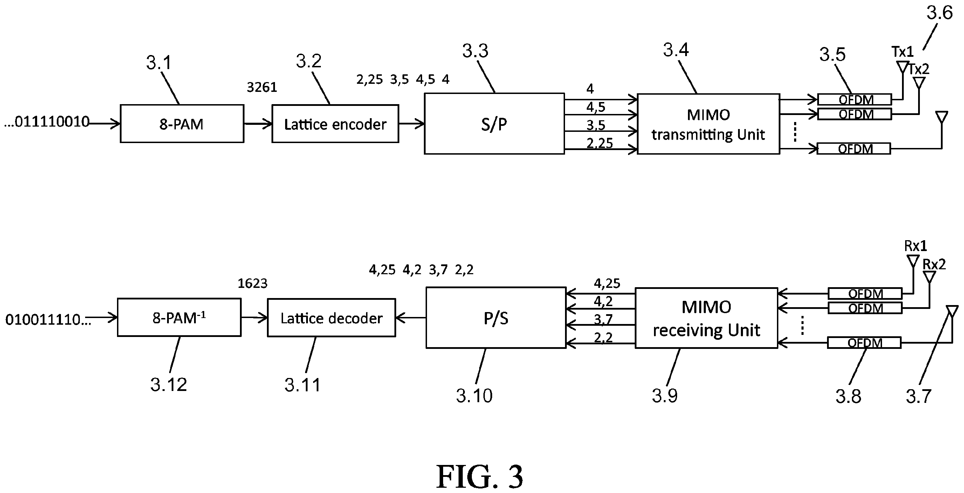

Referring to Figure 3, it is showed a block diagram of a classical MIMO transmitter and a MIMO receiver respectively implementing a lattice encoder and a lattice decoder.

The radio signal is provided by processing data, and more specifically binary sequences, in the transmitter scheme. The transmitter scheme is the same as the one described in figure 2 except that the MCS encoder 2.1 is replaced by a modulator 3.1 and a Lattice encoder 3.2. The modulator 3.1 outputs values which can be associated with integers (for example different levels of amplitude of a signal in a Pulse-amplitude modulation (PAM) modulator).

Each output of the modulator 3.1 may be associated to a number of integers, this number being equal for example to the dimension of the constellation diagram of the modulation scheme used by the modulator 3.1. For example, with a PAM modulator 3.1 the dimension of the constellation diagram is equal to one, therefore, each symbol is represented by one integer also named level.

Based on $n_{Lat}$-tuple of integers $(z_1, \dots, z_n) \in \mathbb{Z}^n$ outputted by the modulator 3.1, the Lattice encoder 3.2 outputs $n_{Lat}$-tuple of real numbers $\sum_{i=1}^n z_i\, e_i \in \mathbb{R}^n$, with $(e_1, \dots, e_n)$ a basis of a Lattice (therefore a basis of $\mathbb{R}^n$), that is $e_i \in \mathbb{R}^n$ and the $(e_1, \dots, e_n)$ are linearly independent. This transformation $(z_1, \dots, z_n) \to \sum_{i=1}^n z_i\, e_i$ is an isomorphism represented by the matrix G, the rows of which are basis vectors.

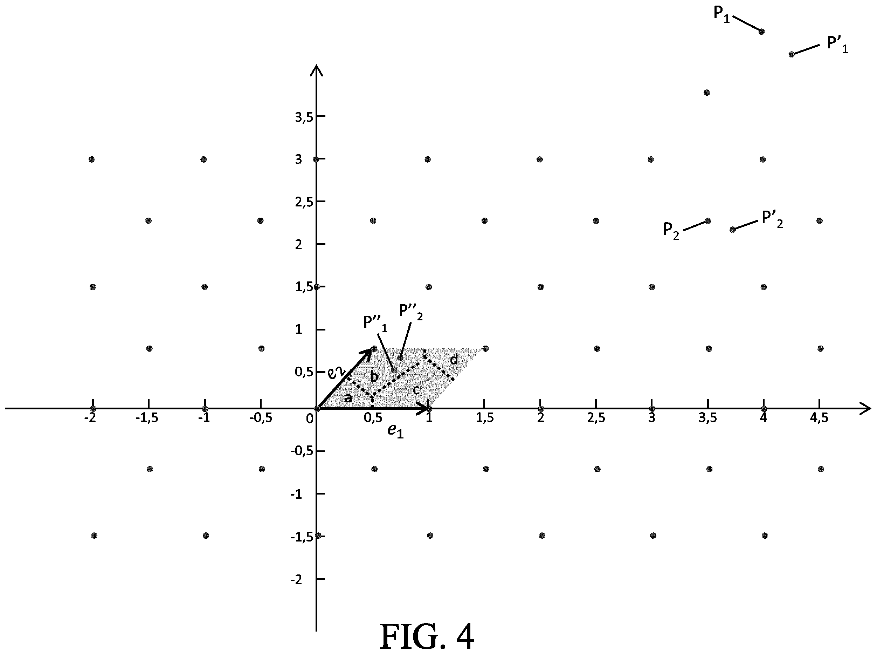

In the example of figure 4 is schematized a two-dimensional Lattice. The points of this lattice (represented in dots on figure 4) are defined as $(z_1\, e_1 + z_2 e_2)$ with $(z_1, z_2) \in \mathbb{Z}^2$. Since $Vector\,(e_1) = (1;\ 0)$ and $Vector\,(e_2) = (0.5;\ 0.75)$ a point $(z_1\, e_1 + z_2 e_2)$ of the Lattice is equal to $\left(z_1 + \frac{1}{2} z_2,\ \frac{3}{4} z_2\right)$. Therefore, for a sequence of integers (1; 6; 2; 3) outputted by the modulator 3.1, the Lattice encoder 3.2 outputs (4; 4.5; 3.5; 2.25), with (4; 4.5) and (3.5; 2.25) two points of the Lattice $P_1$ and $P_2$.

The $n_{Lat}$-tuple of real numbers $\sum_{i=1}^n z_i\, e_i \in \mathbb{R}^n$ is inputted in a serial to parallel module (S/P) 3.3 which outputs $n_{psym}$ parallel symbols, 4 parallel symbols in the example of figure 3. From the inputting of the sequence of $n_{Lat}$ real numbers in the S/P module 3.3 to the emission of the radio signal, the transmitter scheme is identical to the one described in figure 2. That is, at the output of the S/P module 3.3 is applied a MIMO transmitting unit 3.4 (as described in figure 2) and each OFDM encoder 3.5 process the $n_{sc}$ parallel symbols received at his input. The output of each OFDM encoder 3.5 is emitted on each antenna Tx 3.6.

The radio signal is received by the receiver 1.2 on each of its $n_{OFDM/Rx}$ antennas Rx 3.7. From the antennas Rx 3.7 to the output of the P/S module 3.10, the receiver scheme is identical to the one described in figure 2. Indeed, to each signal received is applied an OFDM decoder 3.8. Each of the OFDM decoder 3.8 of the receiver 1.2 outputs $n_{sc}$ parallel symbols which are inputted in the MIMO receiving unit 3.9. The MIMO receiving unit 3.9 decodes the $n_{OFDM/Rx}$ group of $n_{sc}$ symbols respectively outputted by the OFDM decoders 3.8. The MIMO receiving unit 3.9 outputs $n_{psym}$ symbols (as described in figure 2) to which are applied a parallel to serial module 3.10.

The P/S module 3.10 outputs a sequence of real numbers. These real numbers are inputted in the Lattice decoder 3.11 to be processed by tuples of $n_{Dim}$ real numbers ($n_{Dim} = n_{Lat}$), where $n_{Dim}$ is the dimension of the Lattice to which has been configured the Lattice decoder 3.11. Each $n_{Dim}$-tuple of real numbers inputted in the Lattice decoder 3.11, represents a point of $\mathbb{R}^n$. In the example of figure 4, the points $P'_1$ (4.25; 4.20) and $P'_2$ (3.70; 2.20) of $\mathbb{R}^n$ represent the two $n_{Dim}$-tuple of real numbers. The noise and the canal have altered the symbols outputted by the Lattice encoder 3.2. Therefore, the $n_{Dim}$-tuple of real numbers does not correspond to a point of the Lattice. The Lattice decoder 3.2 determines to which point of the Lattice the point of $\mathbb{R}^n$ inputted in the decoder 3.2 is the closest. For this purpose the Lattice decoder may process each of these points by:

- computing $\lfloor P'_1 G^{-1} \rfloor$ and $P''_1 = P'_1 - \lfloor P'_1 G^{-1} \rfloor G$, $P''_1$ being the point in the grey parallelogram representing the Fundamental domain of the Lattice, with $\lfloor X \rfloor$ being defined as $\lfloor Vector(X_1; \dots; X_n) \rfloor = Vector(\lfloor X_1 \rfloor; \dots; \lfloor X_n \rfloor)$ where $\lfloor X_i \rfloor$ is the floor function;

- determining the closest Lattice point $C_1$ to the point $P''_1$ in the Fundamental domain; and

- computing $C'_1 = C_1 + \lfloor P'_1 G^{-1} \rfloor G$.

To determine the closest Lattice point $C_1$ to the point $P''_1$ in the Fundamental domain, the Lattice decoder 3.11 may determine the position of the point $P''_1$ regarding several hyperplanes which divide the Fundamental domain in different zones (a, b, c, d, obtained with 5 hyperplanes in the case of figure 4), the points of each zone being closer to one of the Lattice points of the Fundamental domain. The hyperplanes are the line segment bisector of each segment of the Fundamental domain. In figure 4, P"$_1$ and P"$_2$ are in the zone b, therefore, both are closer to the lattice point at the up left of the Fundamental domain.

Therefore, if the radio channel did not affect too much the radio signal and the noise of the different systems (transmitter 1.1 and receiver 1.2) is limited, the Lattice decoder 3.11 retrieves the correct Lattice point and thus retrieves the correct sequence of integers ($z_1,...,z_n$) ((1; 6; 2; 3) in the case of figure 4). This sequence of integers is transformed into a binary sequence via the demodulator 3.12, which enables to retrieve, at the receiver 1.2 side, the binary sequences emitted by the transmitter 1.1.

The Lattice encoder 3.2 and Lattice decoder 3.11 are defined by their Lattice. That is, for each Lattice encoder/decoder there exists a unique lattice representation.

In the case of the invention which implements such scheme, antennas ports implementing another scheme than an Orthogonal frequency-division multiplexing (OFDM) scheme may be implemented.

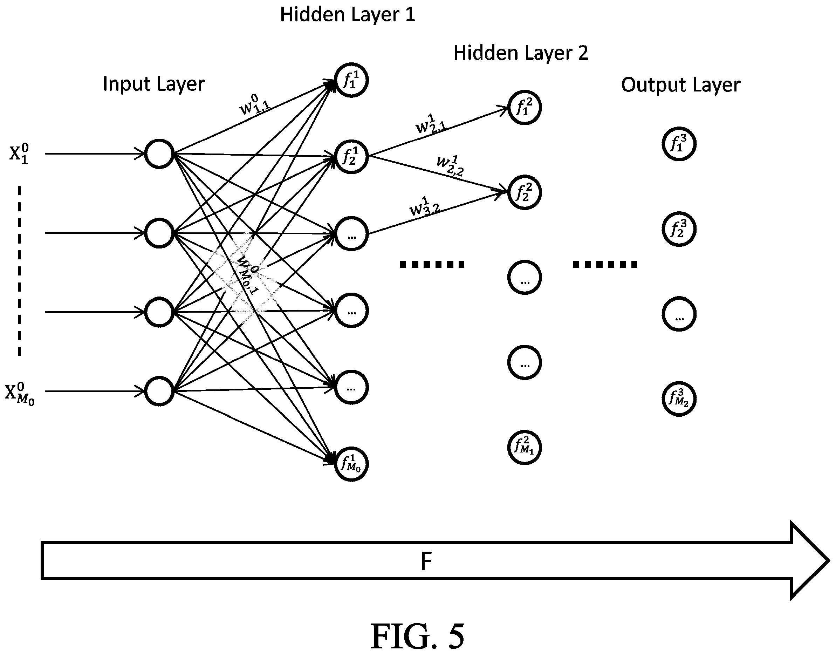

Figure 5 schematizes an ANN system. An ANN system is defined by layers, an input layer, one or more hidden layers and one output layer. Except for the input layer, each layer is composed of nodes to which are inputted weighted values of the previous layer. Input values are inputted in the nodes of the input layer.

Therefore, as represented in figure 5, $X_1^0, ..., X_{M_0}^0$ values are inserted in the input layer. The m-th node of the i-th layer of the ANN system, that is, the node (i; m) can be represented by

$$F_m^i\left(X_1^{i-1}, ..., X_{M_{i-1}}^{i-1}\right) = f_m^i\left(\sum_{k=1}^{M_{i-1}} w_{k,m}^{i-1} \times X_k^{i-1} + \beta_m^i\right)$$

, where $f_m^i$ is an activation function, and $\sum_{k=1}^{M_{i-1}} w_{k,m}^{i-1} \times X_k^{i-1}$ is the weighted sum of the values $X_k^{i-1}$ outputted by each node of the previous layer, $w_{k,m}^{i-1}$ being the weights. In addition, a value $\beta_m^i$ is added to this sum, this value is called a bias or an offset.

The ANN system can therefore be represented by a function F such as

$$F\left(X_1^0, ..., X_{M_0}^0\right) = \left[F_1^N\left(X_1^{N-1}, ..., X_{M_{N-1}}^{N-1}\right), ..., F_{M_N}^N\left(X_1^{N-1}, ..., X_{M_{N-1}}^{N-1}\right)\right]$$

. A ANN decoder may comprise several ANN systems.

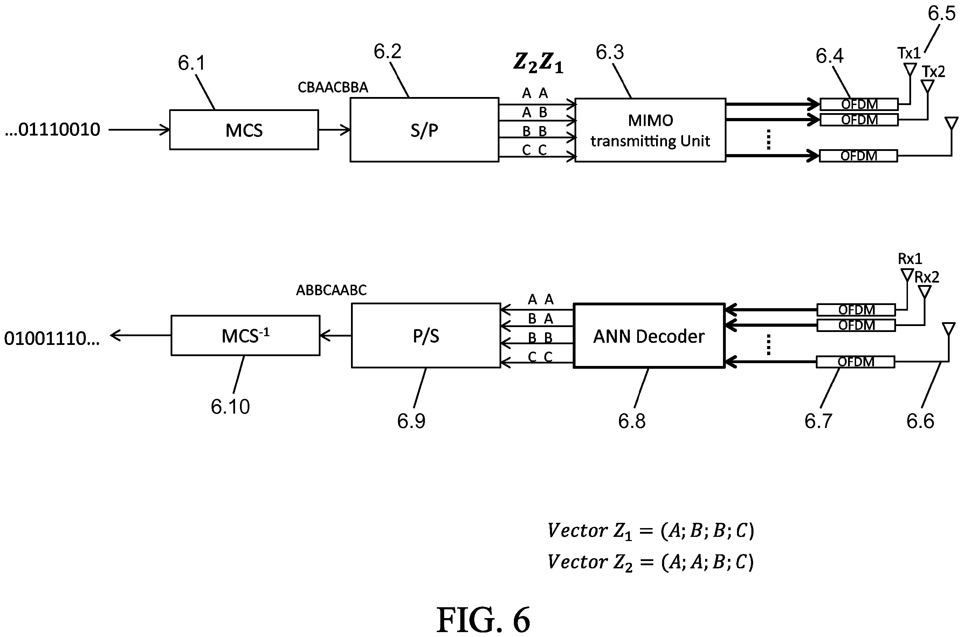

Referring to figure 6 it is showed a block diagram of a classical MIMO transmitter and a receiver implementing a ANN decoder.

The scheme of the transmitter 1.1 is identical to the one described in figure 2. That is, the transmitter scheme implements successively a MCS encoder 6.1, a S/P module 6.2, a MIMO transmitting unit 6.3, OFDM encoders 6.4 and transmitting antennas Tx 6.5.

The scheme of the receiver 1.2 is identical to the one described in figure 2 except that the MIMO receiving unit 2.8 is replaced by a ANN decoder 6.8. That is, the receiver scheme implements successively receiving antennas Rx 6.6, OFDM decoders 6.7, a ANN decoder 6.8, a P/S module 6.9 and a MCS decoder 6.10, all the elements being identical except for the MIMO receiving unit 2.8.

Indeed, the MIMO receiving unit 2.8 is replaced by an ANN decoder 6.8, that is, a decoder comprising at least an ANN system as described in the figure 5. The decoder may be an ANN system or simply a part of the decoder may be ANN system, that is, for example adding pre-processing by a decision feedback equalizer decoder. The decoder may also comprise several ANN systems, for example one ANN system for each MIMO decoder in the MIMO receiving unit 2.8. For the sake of simplicity only an ANN system completely replacing the decoder is described.

As for the MIMO transmitting unit 2.8 of figure 2, the ANN decoder 6.8 receives on its inputs the $n_{sc}$ groups of $n_{OFDM/Rx}$ symbols outputted by the OFDM decoders 6.7. For example, the ANN decoder 6.8 implements an input layer with a node for each of the $n_{OFDM/Rx} \times n_{sc}$ symbols, that is, an input layer containing $n_{OFDM/Rx} \times n_{sc}$ nodes. The ANN decoder 6.8 processes those inputs, and each of the nodes of the output layer outputs a value. The outputted values of the $n_{psym}$ nodes of the output layer represent the $n_{psym}$ parallel symbols.

The symbols of the modulation scheme inputted in the MCS decoder 6.10 may be represented in a P-dimensional space. The P-dimensional space may be the constellation diagram but other representations of the symbols of the modulation type may be chosen, for example all the symbols may be associated with values in a one-dimensional space. However, each symbol of the modulation scheme is defined by P coordinates ($q_1$; ...; $q_P$). The coordinates are real numbers. Therefore, when complex symbols are considered, or more generally complex values, each of them may be decomposed on two coordinates since the ANN system implements activation functions which are $\mathbb{R}$ to $\mathbb{R}$ functions.

The ANN decoder 6.8 may be configured so that at least P' functions $\left(f_{m_1}^N, ..., f_{m_{P'}}^N\right)$

among the functions $f_m^N$ ,that is, P' activation functions of the output layer may be MLAF. The P' functions $\left(f_{m_1}^N, \dots, f_{m_{P'}}^N\right)$ respectively output values of P' coordinates among the P coordinates $(q_1; \dots; q_P)$. When P'=P the output taken by $\left(f_{m_1}^N, \dots, f_{m_{P'}}^N\right)$ represents a point in the P-dimensional space in which are represented the symbols of the modulation type. However, each $f_{m_k}^N$ is a $K_k$-levels activation function, where $K_k$ is equal to the number of values that can take the k-th coordinate among the P' coordinates of the symbols of the modulation type. When P'=P, the number of possible points outputted by $\left(f_{m_1}^N, \dots, f_{m_{P'}}^N\right)$ is at least equal to the number of symbols of the modulation scheme.

Generally, P' is smaller than P, in that case the output layer of the ANN system outputs the P coordinates $(q_1; \dots; q_P)$ in several times, that is, for example, outputting the first P' coordinates of the symbol and then the second P' coordinates of the symbol and so on.

The MLAF that are chosen may be defined as:

$$f_{m_k}^N(x) = \sum_{l=1}^{K_k - 1} B_{l,k}\, f_{l,k}\left(x - \tau_{l,k}\right) + A_k$$

Each $f_{l,k}$ are activation functions (regular activation function), these activation functions may be the same activation function or different activation functions. In the following, for the sake of simplicity the $f_{i,k}$ will all be the same for *l* from 1 to $K_k$ - 1 and k from 1 to P, such activation function will be noted *f*. *f* may be for example a hyperbolic tangent (TanH).

The $\tau_{l,k}$ are distinct real numbers, that is, if $l \neq l' \Rightarrow \tau_{l,k} \neq \tau_{l',k}$. This distinction between the $\tau_{l,k}$ ensures that the activation function has several levels.

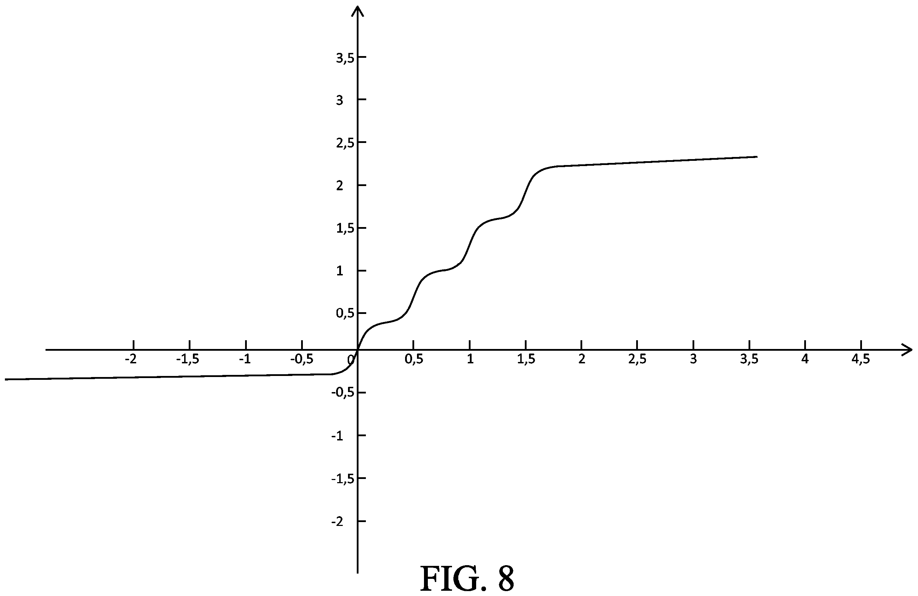

The $A_k$ and the $B_{l,k}$ are real numbers. In figure 8 is shown an example of MLAF function with 5 levels, with the $f_{l,k}$ being hyperbolic tangent functions.

At least for one k from 1 to P', $K_k$ is a positive integer greater than or equal to 3. Indeed, most of the representation in a P-dimensional space of a modulation scheme is done in a compact manner, that is, all the $K_k$ are similar or equal to each other. For example, for k and k' from 1 to P', $K_k$ is either equal to $K_{k'}$, $K_{k'}$+1 or $K_{k'}$-1. In addition, in the modulation scheme used in the new communication standard the number of symbols is important, which involves that the $K_k$, for k from 1 to P', are all greater than 3. For example, with a QAM modulation scheme of 8 symbols, at least one activation function may be a MLAF (with strictly more than 2 levels), with a QAM modulation type of 16 symbols, two activation functions may be MLAFs with each 4 levels.

When considering that the P' coordinates of each of the symbols of the modulation type used by the MCS decoder 6.10 is represented by one of the possible output of the P' functions $\left(f_{m_1}^N, \dots, f_{m_{P'}}^N\right)$ then all the P' coordinates of the different symbols of the modulation scheme can be represented by the output values of only P' $K_k$-levels activation functions, whereas it would have been necessary to use at least $\sum_{k=1}^{P'} K_k - 1$ classical activation functions. Therefore, implementing classical activation functions would necessitate adding a significant amount of nodes in the output layer.

To enable the ANN decoder 6.8 to output the values representing the correct symbols according to the $n_{OFDM/Rx}$ $\times n_{sc}$ symbols inputted in the ANN decoder 6.8, the ANN decoder 6.8 is trained. Therefore, previously to the processing at the receiver side, the ANN decoder 6.8 is trained. The training aims at modifying the parameters of the ANN system, that is $w_{1,m}^{i-1}, \dots, w_{M_{i-1},m}^{i-1}, \beta_m^i$ with m from 1 to $M_i$ and i from 1 to N, so that when the receiver 1.2 receives a radio signal resulting from a specific symbol inputted in the MIMO transmitting unit 6.3 of the transmitter 1.1, the output taken by $\left(f_{m_1}^N, \dots, f_{m_{P'}}^N\right)$, which represents the P' coordinates of a point in the P-dimensional space, is as close as possible to the specific symbol.

The training is performed based on a training set of vectors $\hat{Z}^j$, with *j* from 1 to T. In the case of figure 6, each vector $\hat{Z}^j$ is an input of the MIMO transmitting unit 6.3. Each vector $\hat{Z}^j$ is associated with at least a vector $\hat{X}^j$ obtained by applying to the vectors $\hat{Z}^j$ successive transformations representing part of the transmitter scheme (transformations representing the MIMO transmitting unit 6.3, the OFDM encoders 6.4 and transmitting antennas Tx 6.5), the radio communication channel (represented for example by a channel matrix and a noise vector) and part of the receiver scheme (transformations representing the receiving antennas Rx 6.6 and the OFDM decoders 6.7).

Each vector $\hat{\hat{Z}}^j$ may be associated with more than one vector $\hat{X}^j$ as previously defined. Indeed, there exist many possible successive transformations representing part of the transmitter scheme, the radio communication channel and part of the receiver scheme. For example, several transformations may represent each MIMO encoder of the MIMO transmitting unit 6.3, one transformation for each pre-coding matrix to which may be configured the MIMO encoders. Several transformations may represent the radio communication channel, one transformation for each channel matrix and noise vector that can represent the radio communication channel. More generally, several transformations may represent each component of the transmitter scheme, the receiver scheme and the radio communication channel. Therefore, each vector $\hat{\hat{Z}}^j$ is associated with a group of vectors $\hat{X}^{j,T}$, with $T$ from 1 to S. Two $\hat{X}^{j,T}$ and $\hat{X}^{j,T'}$ are obtained with different transformations $T$ and $T'$ applied to the same vector $\hat{\hat{Z}}^j$, each representing the same components of the transmitter and receiver. However, each transformation may represent a different configuration of these components and/or a different radio communication channel.

The training of the ANN decoder 6.8 comprises comparing respectively the vectors $\hat{\hat{Z}}^j$ with the outputs of the ANN decoder 6.8 when the vectors $\hat{X}^{j,T}$ are inputted to it. If the ANN decoder 6.8 is represented by the function $F$ as described in figure 5, then $\hat{\hat{Z}}^j$ is compared to $F(\hat{X}^{j,T})$ with $\hat{X}^{j,T}$ equal to $\left( \hat{X}_1^{0,j,T}, \dots, \hat{X}_{M_0}^{0,j,T} \right)$. The comparison may be made by a distance $d$. That is, the distances $d(\hat{\hat{Z}}^j; F(\hat{X}^{j,T}))$ are computed for each pair $(T; j)$.

The parameters $w_{1,m}^{i-1}, \dots, w_{M_{i-1},m}^{i-1}, \beta_m^i$, with m from 1 to $M_i$ and i from 1 to N are computed to minimize the distance on the whole training set of vectors $\hat{\hat{Z}}^j$.

For example, the parameters $w_{1,m}^{i-1}, \dots, w_{M_{i-1},m}^{i-1}, \beta_m^i$ may be computed to minimize for example

$$\sum_{j,T} d(\hat{Z}^j; F(\hat{X}^{j,T}))$$ or $$\sum_{j,T} a_j \cdot \left[ d(\hat{Z}^j; F(\hat{X}^{j,T})) \right]$$, where the $a_j$ are weighting factors. The parameters $w_{1,m}^{i-1}, \dots, w_{M_{i-1},m}^{i-1}, \beta_m^i$ influence the values taken by $F(\hat{X}^{j,T})$.

The parameters $w_{1,m}^{i-1}, \dots, w_{M_{i-1},m}^{i-1}, \beta_m^i$ may be computed with a stochastic gradient descent method, where the values of the gradient are obtained with a backpropagation method. Backpropagation is an algorithm used to efficiently compute the gradient of the cost function with respect to the weights used in the network.

For the sake of simplicity, in the above description the S/P module 6.2 has not been taken into account in the training process, indeed, rigorously the vectors $\hat{\hat{Z}}^j$ are not outputs of the MCS encoder 6.1 but outputs of the S/P module 6.2. However, the S/P module 6.2 has not been taken into account since it only changes the training set of row vectors $\hat{\hat{Z}}^j$ to a set of column vectors $(\hat{\hat{Z}}^j)^{tr}$, that is the transpose of the vectors $\hat{\hat{Z}}^j$.

The parameters $K_k, B_{1,k}, \dots, B_{Kk-1,k}, A, \tau_{1,k}, \dots, \tau_{Kk-1,k}$ of each $f_{m_k}^N(x)$ can be set previously to the training of the ANN decoder 6.8 or they can be considered as the parameters of the ANN decoder 6.8 which are modified to reduce the overall gap between respectively the ideal responses and the actual responses of the ANN decoder 6.8. In that case the parameters are $w_{1,m}^{i-1}, \dots, w_{M_{i-1},m}^{i-1}, \beta_m^i$, with m from 1 to $M_i$ and i from 1 to N and $K_k, B_{1,k}, \dots, B_{Kk-1,k}, A, \tau_{1,k}, \dots, \tau_{Kk-1,k}$ for k from 1 to P.

In figure 6 the ANN decoder replaces only the MIMO receiving unit 2.8. Here, the skilled person understands that the ANN decoder may replace additional components of the receiver scheme settled upstream from the MCS decoder 6.10. For example, the ANN decoder may replace the MIMO receiving unit 2.8 and the OFDM decoders 2.7.

Here, the skilled person understands that other schemes than the ones implemented in the transmitter 1.1 and the receiver 1.2 could be implemented. Figure 6 may be transposed with other schemes to the condition that there is a modulator and a demodulator. In that case, the ANN decoder may replace the component which outputs are inputted into the modulator and any component placed before.

Here, the skilled person understands that the ANN system implemented could be different from the feed forward neural network described in figure 5, for example, the ANN implemented could be a recurrent neural network.

In figure 6, it is only described to set MLAFs on the output layer. However, the complexity of the outputs of ANN decoder propagates through the hidden layers of the ANN system. Therefore, it may be relevant to set MLAFs in the hidden layers.

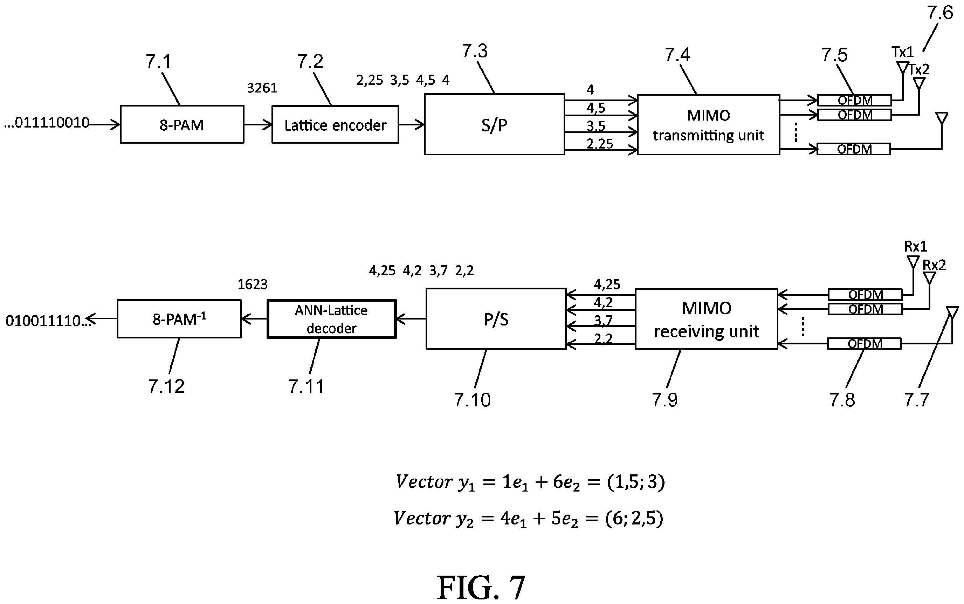

Referring to figure 7 it is showed a block diagram of a classical MIMO transmitter implementing a Lattice encoder and a MIMO receiver implementing an ANN-Lattice decoder according to the invention.

The scheme of the transmitter 1.1 is identical to the one described in figure 3. That is, the transmitter scheme implements successively a modulator 7.1, a Lattice encoder 7.2, a S/P module 7.3, a MIMO transmitting unit 7.4, OFDM encoders 7.5 and transmitting antennas Tx 7.6.

The scheme of the receiver 1.2 is identical to the one described in figure 3 except that the Lattice decoder 3.11 is replaced by an ANN-Lattice decoder 7.11. That is, the receiver scheme implements successively receiving antennas Rx 7.7, OFDM decoders 7.8, a MIMO receiving unit 7.9, a P/S module 7.10, an ANN-Lattice decoder 7.11 and a demodulator 7.12, all the elements being identical except for the Lattice decoder 3.11.

Indeed, the Lattice decoder 3.11 is replaced by an ANN-Lattice decoder 7.11, that is, a decoder comprising an ANN system as described in the figure 5. The decoder may be an ANN system or simply a part of the decoder may be ANN system. For the sake of simplicity only an ANN system completely replacing the Lattice decoder is described.

As for the Lattice decoder 3.11 of figure 3, the ANN-Lattice decoder 7.11 receives on its inputs tuples of $n_{Dim}$ real numbers outputted by the P/S module 7.10, with $n_{Dim}$ being the dimension of the Lattice to which has been configured the Lattice encoder 7.2. The tuple of $n_{Dim}$ real numbers represents a point of of $\mathbb{R}^n$.

The ANN-Lattice decoder 7.11 processes those inputs, and each of the nodes of the output layer outputs a value. These outputted values represent a sequence of $n_{Dim}$ integers. For example, $n_{Dim}$ nodes of the output layer each output an integer. In that case, these $n_{Dim}$ nodes may implement $n_{Dim}$ MLAFs $(f^N_{m_1}, \ldots, f^N_{m_{nDim}})$ among the functions $f^N_m$. Each of the $f^N_{m_k}$ outputs values corresponding to the k-th element of the sequence of $n_{Dim}$ integers. In addition each $f^N_{m_k}$ may be a $K_k$-levels activation function, where $K_k$ is equal to the number of values that can be taken by the k-th element of the sequences of $n_{Dim}$ integers outputted by the modulator 3.1.

The number of nodes on the output layer may be smaller than $n_{Dim}$. In that case, and as described in figure 6, the output layer of the ANN system outputs the $n_{Dim}$ integers in several times. For the sake of simplicity $n_{Dim}$ is considered as smaller than the number of nodes on the output layer.

For the sake of simplicity the $n_{Dim}$ MLAFs may all be K levels activation functions, with K equal to the maximum integer that can output the modulator 7.1. For example, with a 8-level PAM modulator 7.1, the $n_{Dim}$ MLAFs may all be 8 levels activation functions. Therefore, the number of values that can be outputted by each $f^N_{m_k}$ is at least equal to the number of symbols of the modulation scheme used by the modulator 7.12.

When considering that each of the integer of the sequence of integers (the integers being symbols of the modulation scheme used by the modulator 7.12) is represented by the output of one of $f^N_{m_k}$ then all the different sequences of $n_{Dim}$ integers outputted by the modulator 7.1 can be represented by the output values of $(f^N_{m_1}, \ldots, f^N_{m_{nDim}})$.

To enable the ANN-Lattice decoder 7.11 to output the values representing the correct sequences of $n_{Dim}$ integers according to the tuples of $n_{Dim}$ real numbers inputted, the ANN-Lattice decoder 7.11 is trained. That is, previously to the processing at the receiver side, the ANN-Lattice decoder 7.11 is trained. The training aims at modifying the parameters of the ANN system, that is $w^{i-1}_{1,m}, \ldots, w^{i-1}_{M_{i-1},m}, \beta^i_m$ with m from 1 to $M_i$ and i from 1 to N, so that when the receiver 1.2 receives a radio signal resulting from a specific sequence of $n_{Dim}$ integers inputted in the Lattice encoder 7.2 of the transmitter 1.1, the sequence of values outputted by $(f^N_{m_1}, \ldots, f^N_{m_{nDim}})$, is as close as possible to that specific sequence.

The training is performed based on a training set of vectors $\hat{Z}^j \in \mathbb{Z}^{n_{Dim}}$, with j from 1 to T. In the case of figure 7, each vector $\hat{Z}^j$ is an input of the Lattice encoder 7.2. Each vector $\hat{Z}^j$ is associated with at least a vector $\hat{X}^j \in \mathbb{R}^{n_{Dim}}$ obtained by applying to the vectors $\hat{Z}^j$ successive transformations representing part of the transmitter scheme (transformations representing the Lattice encoder 7.2, the S/P module 7.3, the MIMO transmitting unit 7.4, the OFDM encoders 7.5 and the transmitting antennas Tx 7.6), the radio communication channel (represented for example by a channel matrix and a noise vector) and part of the receiver scheme (transformations representing the receiving antennas Rx 7.7, the OFDM encoders 7.8, the MIMO receiving unit 7.9 and the P/S module 7.10).

Each vector $\hat{Z}^j$ may be associated with more than one vector $\hat{X}^j$ as previously defined. Indeed, there exist many possible successive transformations representing part of the transmitter scheme, the radio communication channel and part of the receiver scheme. For example, several transformations may represent each MIMO encoder of the MIMO transmitting unit 7.4, one transformation for each pre-coding matrix to which may be configured the MIMO encoders. Several transformations may represent the radio communication channel, one transformation for each channel matrix and noise vector that can represent the radio communication channel. More generally, several transformations may represent each component of the transmitter scheme, the receiver scheme and the radio communication channel. Therefore, each vector $\hat{Z}^j$ is associated with a group of vectors $\hat{X}^{j,T}$, with $T$ from 1 to S. Two $\hat{X}^{j,T}$ and $\hat{X}^{j,T'}$ are obtained with different transformations $T$ and $T'$ applied to the same vector $\hat{Z}^j$, each representing the same components of the transmitter and receiver. However, each transformation may represent a different configuration of these components and/or a different radio communication channel.

The training of the ANN-Lattice decoder 7.11 comprises comparing respectively the vectors $\hat{Z}^j$ with the outputs of the ANN-Lattice decoder 7.11 when the vectors $\hat{X}^{j,T}$ are inputted to it. If the ANN-Lattice decoder 7.11 is represented by the function $F$ as described in figure 5, then $\hat{Z}^j$ is compared to $F(\hat{X}^{j,T})$ with $\hat{X}^{j,T}$ equal to $\left( \hat{X}_1^{0,j,T}, \ldots, \hat{X}_{M_0}^{0,j,T} \right)$. The comparison may be made by a distance $d$. That is, the distances $d(\hat{Z}^j; F(\hat{X}^{j,T}))$ are computed for each pair (T; j).

The parameters $w_{1,m}^{i-1}, \ldots, w_{M_{i-1},m}^{i-1}, \beta_m^i$, with m from 1 to $M_i$ and i from 1 to N are computed to minimize the distance on the whole training set of vectors $\hat{Z}^j$.

For example, the parameters $w_{1,m}^{i-1}, \ldots, w_{M_{i-1},m}^{i-1}, \beta_m^i$ may be computed to minimize for example $\sum_{j,T} d(\hat{Z}^j; F(\hat{X}^{j,T}))$ or $\sum_{j,T} a^{jT}.[d(\hat{Z}^j; F(\hat{X}^{j,T}))]$, where the $a_j$ are weighting factors. The parameters $w_{1,m}^{i-1}, \ldots, w_{M_{i-1},m}^{i-1}, \beta_m^i$ influences the values taken by $F(\hat{X}^{j,T})$.

The parameters $w_{1,m}^{i-1}, \ldots, w_{M_{i-1},m}^{i-1}, \beta_m^i$ may be computed with a backpropagation method.

As explained in the description related to figure 3, the Lattice decoder 3.11 or the ANN-Lattice decoder 7.11 receives $n_{Dim}$-tuple of real numbers which represents a point P' (P'$_1$ or P'$_2$ on figure 4) in $\mathbb{R}^{n_{Dim}}$, where $n_{Dim}$ is the dimension of the Lattice. Generally, the point P' is not a point of the Lattice since the noise and the canal have altered the $n_{Dim}$-tuple of real numbers (representing a point P (P$_1$ or P$_2$ on figure 4) of the Lattice) outputted by the Lattice encoder 7.2. Therefore, the Lattice decoders must determine to which point of the Lattice $\sum_{i=1}^{n_{Dim}} z_i \, e_i \in \mathbb{R}^{n_{Dim}}$, with $(z_1, \ldots, z_n) \in \mathbb{Z}^{n_{Dim}}$, the point P' is the closest. To that end the Lattice decoders may determine the position of the point P' (or a point in the Fundamental domain P''(P''$_1$ or P''$_2$ on figure 4), which results from a translation of P' by a vector $\sum_{i=1}^{n_{Dim}} t_i \, e_i$, with $t_1, \ldots, t_n$ integers) regarding several hyperplanes (the hyperplanes are the perpendicular bisector hyperplanes of each segment of the Fundamental domain) which divide the Fundamental domain (or the domain which results from a translation of the Fundamental domain by the vector $\sum_{i=1}^{n_{Dim}} -t_i \, e_i$ in different zones (a, b, c, d, obtained with 5 hyperplanes in the case of figure 4). Indeed, all the points of one of the zones are closer to a unique point of the Lattice of the Fundamental domain. Therefore to determine if a point is in one zone, the Lattice decoders may determine on what side of each hyperplane delimiting the zone the point is. For example, in the case of figure 4, to determine if a point is in the zone "a", the Lattice decoder may determine if the point is on the left of the vertical hyperplane delimiting the "a" zone and under the oblique hyperplane delimiting the "a" zone, those two conditions are required. To determine if a point is in the zone "c", the Lattice decoder may determine if the point is on the right of the vertical hyperplane delimiting the "c" zone and under the two oblique hyperplane delimiting the "c" zone, three conditions are now required. Therefore, even in a two-dimensional Lattice, determining the position of the point P is complex. This complexity grows in a non-linear manner when the dimension of the Lattice becomes bigger. However, even in a two-dimensional lattice determining in what zone the point is, requires at least one node for each hyperplane dividing the Fundamental domain.

In the case of the Lattice of figure 4, it requires five activation functions and thus five nodes to determine where a point is in the Fundamental domain. It is possible to reduce this number of nodes. For example, by replacing the activation functions outputting positions of a point relatively to two hyperplanes which are parallel, by one 3-level MLAF. More generally, each edge of the Fundamental domain of an $n_{Dim}$ dimensional Lattice is parallel to $2^{n_{Dim}-1} - 1$ other edges of the Fundamental domain. Therefore, when dividing the Fundamental domain, perpendicular bisector hyperplanes of the $2^{n_{Dim}-1}$ parallel edges of the Fundamental domain are used. These $2^{n_{Dim}-1}$ perpendicular bisector hyperplanes may for some of them coincide (but at least 2 hyperplanes do not and most of the time none of them do) or all of them coincide in one hyperplane if the vector of the Lattice basis, which has the same direction as these edges, is orthogonal to all the other vectors of the basis. Therefore, it is possible to reduce the number of nodes of the ANN-Lattice decoder configured with a non-orthogonal Lattice, for example, by replacing the activation functions outputting positions of a point relatively to $2^{n_{Dim}-1}$ hyperplanes which are parallel, by one ($2^{n_{Dim}-1} + 1$)-level MLAF. These problems are multiclass classification problems which occur regardless to the structure and the training of the ANN system.

Therefore, this complex computing, which requires ANN system with an important amount of nodes implementing regular activation functions, may be carried out by an ANN system with a reduced amount of nodes if MLAFs are implemented in the nodes of the hidden layers.

Therefore, the ANN-Lattice decoder 7.11 is implemented with at least one ($2^{n_{Dim}-1} + 1$)-levels MLAF (or at least a 3 levels MLAF) on at least one of the hidden layers or on all the hidden layers. All the nodes of a layer may be implemented with such MLAF.

The MLAF used in the embodiment described in figure 7 may be defined as:

$$\sum_{l=1}^{K-1} B_l\, f_l(x - \tau_l) + A$$

Each $f_l$ are activation function, these activation functions may be the same or different activation function. For example, the $f_l$ may be hyperbolic tangent (TanH) functions.

The $\tau_l$ are distinct real numbers, that is, if $l \neq l' \Rightarrow \tau_l \neq \tau_{l'}$. This distinction between the $\tau_l$ ensures that the activation function has several levels.

The A and the $B_l$ are real numbers.

K is an integer equal or greater than ($2^{n_{Dim}-1} + 1$) (or at least equal or greater than 3).

The parameters $K, B_1, ..., B_{K-1}, A, \tau_1, ..., \tau_{K-1}$ of each MLAF used in the ANN-Lattice decoder 7.11 may be the same for all the MLAFs or may be different for each MLAF or may be the same only for all the MLAFs implemented in the output layer of the ANN system and the same only for all the MLAFs implemented in the hidden layers.

These parameters can be set previously to the training of the ANN-Lattice decoder 7.11 or they can be considered as the parameters of the ANN-Lattice decoder 7.11 which are determined during the training of the ANN system. In that case the parameters are $w_{1,m}^{i-1}, ..., w_{M_{i-1},m}^{i-1}, \beta_m^i$, with m from 1 to $M_i$ and i from 1 to N to which are added the parameters of each MLAF used in the ANN-Lattice decoder 7.11.

In figure 7 the ANN decoder replaces only the Lattice decoder 3.11. Here, the skilled person understands that the ANN decoder may replace additional components of the receiver scheme settled upstream and downstream from the ANN-Lattice decoder 7.11. For example, the ANN decoder replaces the Lattice decoder 7.11 and may also replace the P/S module 7.10 and the MIMO transmitting unit 7.9 and even the OFDM decoders 7.8.

Here, the skilled person understands that other schemes than the ones implemented in the transmitter 1.1 and the receiver 1.2 could be implemented. Figure 7 may be transposed with any other schemes to the condition that there is a Lattice encoder and a Lattice decoder. In that case, the ANN decoder replaces at least the Lattice decoder and may also replace any component placed before or after this Lattice decoder. For example, a shaping module may be added to the scheme described in figure 3 between the modulator 3.1 and the lattice encoder 3.2 and inverse shaping module between the demodulator 3.12 and the Lattice decoder 3.11. Such shaping modules modify the sequences of integers inputted in the Lattice encoder 3.2 to ensure that all the possible sequences outputted by the Lattice encoder 3.2 are compact according to the possible sequences of integers outputted by the modulator 3.1. That is, that the possible Lattice points outputted by the Lattice encoder 3.2 according to the possible outputs of the modulator 3.1 are in the smallest possible sphere around zero to reduce the average transmitting power.

Here, the skilled person understands that the ANN system implemented could be different from the feed forward neural network described in figure 5, for example, the ANN implemented could be a recurrent neural network.

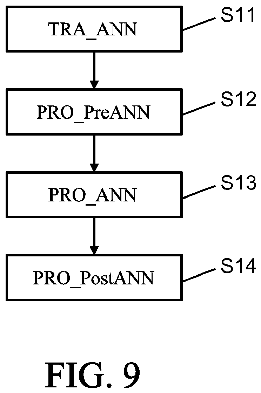

Referring to figure 9 is shown a flowchart representing the decoding of a radio signal.

At step S11 the ANN decoder, which in the case described in figure 6 is the ANN decoder 6.8 and in the case described in figure 7 is the ANN-Lattice decoder 7.11, is trained on a training set of vectors $\hat{Z}^j$ and their respective associated groups of vectors $\overset{\wedge}{X}{}^{j,T}$, as described in figures 6 and 7. The training may be carried out to determine only the parameters $w_{1,m}^{i-1}, \dots, w_{M_{i-1},m}^{i-1}, \beta_m^i$ with m from 1 to $M_i$ and i from 1 to N or these parameters to which are added the parameters defining each MLAF implemented in the ANN system.

The parameters determined may be saved in the MEMO_recei 1.8 and retrieved to configure the ANN system.

At step S12 the radio signal received by the receiver 1.2 is processed by the components settled upstream from the ANN decoder, that is, by the OFDM decoders 6.7 in the embodiment of figure 6 and by the OFDM decoders 7.8, the MIMO receiving unit 7.9 and the P/S module 7.10 in the embodiment of figure 7.

At step S13 the symbols outputted by the processing carried out at step S12 are inputted into the ANN decoder, which decodes these symbols to retrieve the modulation symbols outputted by the MCS encoder 6.1 in figure 6 and the sequence of integers outputted by the modulator 7.1 in figure 7 to the condition that the radio channel did not affect too much the radio signal and the noise of the different systems (transmitter 1.1 and receiver 1.2) is limited.

At step S14 the output of the ANN decoder is processed according to the component of the receiver scheme settled at the downstream of the ANN decoder to retrieve the binary sequence which represents the data transmitted.

**Claims**

1. A computer-implemented method for decoding at least $M_0$ symbols $X_1^0, \dots, X_{M_0}^0$ received from a transmitter through a wireless communication medium, said received symbols representing symbols encoded by an encoder E of the transmitter, said method comprising:

   inputting in a decoder the $M_0$ symbols $X_1^0, \dots, X_{M_0}^0$ , said decoder comprising an artificial neural network system with N layers,

   wherein the decoder is defined as a function F which is defined by N sets of functions $F_1^i, \dots, F_{M_i}^i$ , with i from 1 to N, wherein each Function $F_m^i$ corresponds to a neuron of the i-th layer of said artificial neural network system, wherein $F_m^i(X_1^{i-1}, \dots, X_{M_{i-1}}^{i-1}) = f_m^i(\sum_{k=1}^{M_{i-1}} w_{k,m}^{i-1} \times X_k^{i-1} + \beta_m^i)$ , with $F(X_1^0, \dots, X_{M_0}^0) = [F_1^N(X_1^{N-1}, \dots, X_{M_{N-1}}^{N-1}), \dots, F_{M_N}^N(X_1^{N-1}, \dots, X_{M_{N-1}}^{N-1})]$ , where, $X_m^{i-1}$ are respectively the outputs of the functions $F_m^{i-1}$, $X_m^{i-1} = F_m^{i-1}(X_1^{i-2}, \dots, X_{M_{i-1}}^{i-2})$ of the (i-1)-th set, wherein each $f_m^i$ is either an artificial neural network activation function or an identity function, and $w_{1,m}^{i-1}, \dots, w_{M_{i-1},m}^{i-1}, \beta_m^i$ for m from 1 to $M_i$ and for i from 1 to N are real number parameters of said artificial neural network,

   wherein at least one of the functions $f_m^i$ with m from 1 to $M_i$ and i from 1 to N-1 is a multiple level activation function; wherein a multiple level activation function is an activation function that enables to consider strictly more than two levels of output.

2. The method according to claim 1, wherein the artificial neural network system is trained on a training set of vectors $\overset{\wedge}{Z}{}^j$, each vector $\overset{\wedge}{Z}{}^j$ being compared with the output of the artificial neural network system when applied to a vector $\overset{\wedge}{X}{}^{j,T}$, with $\hat{X}^j = (\hat{X}_1^{0,j}, \dots, \hat{X}_{M_0}^{0,j})$ , the vectors $\overset{\wedge}{X}{}^j$ being obtained by applying respectively to the vectors $\overset{\wedge}{Z}{}^j$ successively a first transformation representing the encoder E and a second transformation representing at least:

   - a transmitting scheme of the transmitter, said transmitting scheme following the encoder E, and
   - a radio communication channel.

3. The method according to any one of the precedent claims, wherein said parameters $w_{1,m}^{i-1}, \dots, w_{M_{i-1},m}^{i-1}, \beta_m^i$ , with m from 1 to $M_i$ and i from 1 to N are computed to minimize a distance between respectively outputs $F(\hat{X}_1^{0,j}, \dots, \hat{X}_{M_0}^{0,j})$ of the decoder and vectors $\overset{\wedge}{Z}{}^j$ of a training set of vectors, with $\hat{Z}^j = (\hat{Z}_1^j, \dots, \hat{Z}_{M_N}^j)$ , the

vectors $\hat{X}j$, with $\hat{X}^j = (\hat{X}_1^{0,j}, ..., \hat{X}_{M_0}^{0,j})$, being obtained by applying respectively to the vectors $\hat{Z}j$ successively a first transformation representing the encoder E and a second transformation representing at least:

- a transmitting scheme of the transmitter, said transmitting scheme following the encoder E, and
- a wireless communication channel.

4. The method according to any one of the precedent claims, wherein the multiple level activation function is defined as:

$$f_{K,B_1,...,B_{K-1},A,\tau_1,...,\tau_{K-1}}(x) = \sum_{l=1}^{K-1} B_l\, f_l(x - \tau_l) + A$$

with each $f_l$ being an activation function,
with $\tau_l$ being real numbers, and if $l \neq l' \Rightarrow \tau_l \neq \tau_{l'}$,
with A and the $B_l$ being real numbers
and K a positive integer greater than or equal to 3.

5. The method according to any one of the precedent claims, wherein inputs of the encoder E are connected to outputs of a Modulation encoder.

6. The method according to claim 5, wherein at least one of the functions $f_m^N$ with m from 1 to $M_N$, is a multiple level activation function.

7. The method according to claim 6, wherein symbols in a modulation type used by the Modulation encoder are each defined by P coordinates $(q_1; ...; q_P)$, wherein at least P' functions $(f_{m_1}^N, ..., f_{m_{P'}}^N)$ among the functions $f_m^N$, with m from 1 to $M_N$, respectively output values of P' coordinates among the P coordinates $(q_1; ...; q_P)$ and wherein for each k from 1 to P', $f_{m_k}^N$ being a $K_k$-level multiple level activation function, where $K_k$ is equal to the number of values that can take the k-th coordinate among the P' coordinates of the symbols of the modulation type.

8. The method according to any one of claims 1 to 7, wherein the encoder E comprises a Lattice encoder, wherein inputs of the Lattice encoder being inputs of the encoder E.

9. The method according to any one of the precedent claims, wherein the encoder E comprises a MIMO encoder.

10. Computer program product comprising code instructions to perform the method according to any one of claims 1 to 9, when said instructions are run by a processor.

11. A device for receiving $M_0$ symbols $X_1^0, ..., X_{M_0}^0$ from a transmitter through a wireless communication medium, said received symbols representing symbols encoded by an encoder E of the transmitter, the device comprises:

- a reception module ; and
- a decoder, said decoder comprising an artificial neural network system with N layers;

wherein the decoder is defined as a function *F* which is defined by N sets of functions $F_1^i, ..., F_{M_i}^i$, with i from 1 to N, wherein each Function $F_m^i$ corresponds to a neuron of the i-th layer of said artificial neural network system, wherein $F_m^i(X_1^{i-1}, ..., X_{M_{i-1}}^{i-1}) = f_m^i\left(\sum_{k=1}^{M_{i-1}} w_{k,m}^{i-1} \times X_k^{i-1} + \beta_m^i\right)$, with $F(X_1^0, ..., X_{M_0}^0) = [F_1^N(X_1^{N-1}, ..., X_{M_{N-1}}^{N-1}), ..., F_{M_N}^N(X_1^{N-1}, ..., X_{M_{N-1}}^{N-1})]$, where, $X_m^{i-1}$ are respectively the outputs of the functions $F_m^{i-1}$, $X_m^{i-1} = F_m^{i-1}(X_1^{i-2}, ..., X_{M_{i-1}}^{i-2})$ of the (i-1)-th set, wherein each $f_m^i$ is either an artificial neural network activation function or an identity function, and $w_{1,m}^{i-1}, ..., w_{M_{i-1},m}^{i-1}, \beta_m^i$ for m from 1 to $M_i$ and for i from 1 to N are real number parameters of said artificial neural network,

wherein at least one of the functions $f_m^i$ with m from 1 to $M_i$ and i from 1 to N-1 is a multiple level activation function; wherein a multiple level activation function is an activation function that enables to consider strictly more than two levels of output.

**Patentansprüche**

1. Computer-implementiertes Verfahren zum Decodieren von mindestens $M_0$ Symbolen $X_1^0, ..., X_{M_0}^0$ empfangen von einem Sender über ein drahtloses Kommunikationsmedium, wobei die empfangenen Symbole Symbole darstellen, die von einem Encoder E des Senders kodiert wurden, wobei das Verfahren umfasst:

Eingeben der $M_0$ Symbole $X_1^0, ..., X_{M_0}^0$ in einen Decoder, wobei der Decoder ein künstliches neuronales Netzwerksystem mit N Schichten umfasst,

wobei der Decoder als eine Funktion $F$ definiert ist, die durch N Sätze von Funktionen $F_1^i, ..., F_{M_i}^i$ definiert ist, mit i von 1 bis N, wobei jede Funktion $F_m^i$ einem Neuron der i-ten Schicht des künstlichen neuronalen Netzwerksystems entspricht, wobei

$$F_m^i\left(X_1^{i-1}, ..., X_{M_{i-1}}^{i-1}\right) = f_m^i\left(\sum_{k=1}^{M_{i-1}} w_{k,m}^{i-1} \times X_k^{i-1} + \beta_m^i\right),$$ mit

$$F\left(X_1^0, ..., X_{M_0}^0\right) = \left[F_1^N\left(X_1^{N-1}, ..., X_{M_{N-1}}^{N-1}\right), ..., F_{M_N}^N\left(X_1^{N-1}, ..., X_{M_{N-1}}^{N-1}\right)\right],$$ worin

$X_m^{i-1}$ jeweils die Ausgaben der Funktionen $F_m^{i-1}$, $X_m^{i-1} = F_m^{i-1}(X_1^{i-2}, ..., X_{M_{i-1}}^{i-2})$ des (i-1)-ten Satzes sind, wobei jedes $f_m^i$ entweder eine künstliche neuronale Netzwerk-Aktivierungsfunktion oder eine Identitätsfunktion ist, und

$w_{1,m}^{i-1}, ..., w_{M_{i-1},m}^{i-1}, \beta_m^i$ für m von 1 bis $M_i$ und für i von 1 bis N reelle Zahlenparameter des künstlichen neuronalen Netzwerks sind,

wobei mindestens eine der Funktionen $f_m^i$ mit m von 1 bis $M_i$ und i von 1 bis N-1 eine Mehrschicht-Aktivierungsfunktion ist,
wobei eine Mehrschicht-Aktivierungsfunktion eine Aktivierungsfunktion ist, die ermöglicht, streng mehr als zwei Schichten an Ausgabe zu berücksichtigen.

2. Verfahren nach Anspruch 1, wobei das künstliche neuronale Netzwerksystem an einem Trainingssatz von Vektoren $\hat{Z}^j$ trainiert wird, wobei jeder Vektor $\hat{Z}^j$ verglichen wird mit der Ausgabe des künstlichen neuronalen Netzwerks, wenn es auf einen Vektor $\hat{X}^{j,T}$ angewendet wird, mit $\hat{X}^j = (\hat{X}_1^{0,j}, ..., \hat{X}_{M_0}^{0,j})$, wobei die Vektoren $\hat{X}^j$ dadurch erhalten werden, dass jeweils auf die Vektoren $\hat{Z}^j$ nacheinander eine erste Transformation angewendet wird, die den Encoder E darstellt, und eine zweite Transformation, die mindestens darstellt:

- ein Sendeschema des Senders, wobei das Sendeschema dem Encoder E folgt, und
- einen Funkkommunikationskanal.

3. Verfahren nach einem der vorhergehenden Ansprüche, wobei die Parameter $w_{1,m}^{i-1}, ..., w_{M_{i-1},m}^{i-1}, \beta_m^i$, mit m von 1 bis $M_i$ und i von 1 bis N, berechnet werden, um eine Distanz jeweils zwischen den Ausgaben

$F(\widehat{X}_1^{0,j}, ..., \widehat{X}_{M_0}^{0,j})$ des Decoders und Vektoren $\hat{Z}^j$ eines Trainingssatzes an Vektoren zu minimieren, mit

$\hat{Z}^j = \left(\hat{Z}_1^J, ..., \hat{Z}_{M_N}^J\right)$, wobei die Vektoren $\hat{X}^j$, mit $\hat{X}^j = \left(\widehat{X}_1^{0,j}, ..., \widehat{X}_{M_0}^{0,j}\right)$, dadurch erhalten werden, dass jeweils auf die Vektoren $\hat{Z}^j$ nacheinander eine erste Transformation angewendet wird, die den Encoder E darstellt, und eine zweite Transformation, die mindestens darstellt:

- ein Sendeschema des Senders, wobei das Sendeschema dem Encoder E folgt, und
- einen kabellosen Kommunikationskanal.

4. Verfahren nach einem der vorhergehenden Ansprüche, wobei die Mehrschicht-Aktivierungsfunktion definiert ist als:

$$f_{K,B_1,...,B_{K-1},A,\tau_1,...,\tau_{K-1}}(x) = \sum_{l=1}^{K-1} B_l f_l(x - \tau_l) + A$$

wobei jedes $f_l$ eine Aktivierungsfunktion ist,
wobei $\tau_l$ reelle Zahlen sind, und wenn $l \neq l' \Rightarrow \tau_l \neq \tau_{l'}$,
wobei A und die $B_l$ reelle Zahlen sind
und K eine positive ganze Zahl größer als oder gleich 3 ist.

5. Verfahren nach einem der vorhergehenden Ansprüche, wobei Eingaben des Encoders E verbunden sind mit Ausgaben eines Modulations-Encoders.

6. Verfahren nach Anspruch 5, wobei mindestens eine der Funktionen $f_m^N$ mit m von 1 bis $M_N$ eine Mehrschicht-Aktivierungsfunktion ist.

7. Verfahren nach Anspruch 6, wobei Symbole in einem Modulationstyp verwendet vom Modulations-Encoder jeweils durch P Koordinaten ($q_1$; ...; $q_P$) definiert sind, wobei mindestens P' Funktionen ( $f_{m_1}^N, ..., f_{m_{P'}}^N$ ) unter den Funktionen $f_m^N$, mit m von 1 bis $M_N$, jeweils Werte von P' Koordinaten unter den P Koordinaten ($q_1$; ...; $q_P$) ausgeben und wobei für jedes k von 1 bis P' $f_{m_k}^N$ eine $K_k$-Schicht Mehrschicht-Aktivierungsfunktion ist, wobei $K_k$ gleich der Anzahl von Werten ist, die die k-te Koordinate unter den P' Koordinaten der Symbole des Modulationstyps annehmen kann.

8. Verfahren nach einem der Ansprüche 1 bis 7, wobei der Encoder E einen Gitter-Encoder umfasst, wobei Eingaben des Gitter-Encoders Eingaben des Encoders E sind.

9. Verfahren nach einem der vorhergehenden Ansprüche, wobei der Encoder E einen MIMO-Encoder umfasst.

10. Computerprogramm-Produkt umfassend Code-Anweisungen, um das Verfahren nach einem der Ansprüche 1 bis 9 durchzuführen, wenn die Anweisungen von einem Prozessor ausgeführt werden.

11. Vorrichtung zum Empfangen von $M_0$ Symbolen $X_1^0, ..., X_{M_0}^0$ von einem Sender über ein drahtloses Kommunikationsmedium, wobei die empfangenen Symbole Symbole darstellen, die von einem Encoder E des Senders kodiert wurden, wobei die Vorrichtung umfasst:

- ein Empfangsmodul; und
- einen Decoder, wobei der Decoder ein künstliches neuronales Netzwerksystem mit N Schichten umfasst, wobei der Decoder als eine Funktion F definiert ist, die durch N Sätze von Funktionen $F_1^i, ..., F_{M_i}^i$ definiert ist, mit i von 1 bis N, wobei jede Funktion $F_m^i$ einem Neuron der i-ten Schicht des künstlichen neuronalen Netzwerksystems entspricht, wobei

$$F_m^i\big(X_1^{i-1}, \ldots, X_{M_{i-1}}^{i-1}\big) = f_m^i\big(\sum_{k=1}^{M_{i-1}} w_{k,m}^{i-1} \times X_k^{i-1} + \beta_m^i\big) \quad, \quad \text{mit}$$

$$F\big(X_1^0, \ldots, X_{M_0}^0\big) = \Big[F_1^N\big(X_1^{N-1}, \ldots, X_{M_{N-1}}^{N-1}\big), \ldots, F_{M_N}^N\big(X_1^{N-1}, \ldots, X_{M_{N-1}}^{N-1}\big)\Big] \quad, \quad \text{worin}$$

$X_m^{i-1}$ jeweils die Ausgaben der Funktionen $F_m^{i-1}$, $X_m^{i-1} = F_m^{i-1}(X_1^{i-2}, \ldots, X_{M_{i-1}}^{i-2})$ des (i-1)-ten Satzes sind, wobei jedes $f_m^i$ entweder eine künstliche neuronale Netzwerk-Aktivierungsfunktion oder eine Identitätsfunktion ist, und

$w_{1,m}^{i-1}, \ldots, w_{M_{i-1},m}^{i-1}, \beta_m^i$ für m von 1 bis $M_i$ und für i von 1 bis N reelle Zahlenparameter des künstlichen neuronalen Netzwerks sind,

wobei mindestens eine der Funktionen $f_m^i$ mit m von 1 bis $M_i$ und i von 1 bis N-1 eine Mehrschicht-Aktivierungsfunktion ist,

wobei eine Mehrschicht-Aktivierungsfunktion eine Aktivierungsfunktion ist, die ermöglicht, streng mehr als zwei Schichten an Ausgabe zu berücksichtigen.

## Revendications

1. Procédé mis en oeuvre par ordinateur pour le décodage d'au moins $M_0$ symboles $X_1^0, \ldots, X_{M_0}^0$ reçus en provenance d'un émetteur par le biais d'un support de communication sans fil, lesdits symboles reçus représentant des symboles codés par un codeur E de l'émetteur, ledit procédé comprenant :

l'entrée, dans un décodeur, des $M_0$ symboles $X_1^0, \ldots, X_{M_0}^0$, ledit décodeur comprenant un système de réseau de neurones artificiels ayant N couches,

dans lequel le décodeur est défini comme une fonction F qui est définie par N ensembles de fonctions $F_1^i, \ldots, F_{M_i}^i$, avec i de 1 à N, dans lequel chaque fonction $F_m^i$ correspond à un neurone de la i-ème couche dudit système de réseau de neurones artificiels, dans lequel

$$F_m^i\big(X_1^{i-1}, \ldots, X_{M_{i-1}}^{i-1}\big) = f_m^i\big(\sum_{k=1}^{M_{i-1}} w_{k,m}^{i-1} \times X_k^{i-1} + \beta_m^i\big) \quad, \quad \text{avec}$$

$$F\big(X_1^0, \ldots, X_{M_0}^0\big) = \Big[F_1^N\big(X_1^{N-1}, \ldots, X_{M_{N-1}}^{N-1}\big), \ldots, F_{M_N}^N\big(X_1^{N-1}, \ldots, X_{M_{N-1}}^{N-1}\big)\Big] \quad, \quad \text{où,} \quad X_m^{i-1} \quad \text{sont respec-}$$

tivement les sorties des fonctions $F_m^{i-1}$, $X_m^{i-1} = F_m^{i-1}\big(X_1^{i-2}, \ldots, X_{M_{i-1}}^{i-2}\big)$ du (i-1)-ième ensemble, dans lequel chaque $f_m^i$ est soit une fonction d'activation de réseau de neurones artificiels, soit une fonction d'identité, et

$w_{1,m}^{i-1}, \ldots, w_{M_{i-1},m}^{i-1}, \beta_m^i$ pour m de 1 à $M_i$ et pour i de 1 à N sont des paramètres en nombre réel dudit réseau de neurones artificiels,

dans lequel au moins l'une des fonctions $f_m^i$ avec m de 1 à $M_i$ et i de 1 à N-1 est une fonction d'activation à niveaux multiples ;

dans lequel une fonction d'activation à niveaux multiples est une fonction d'activation qui permet de considérer strictement plus de deux niveaux de sortie.

2. Procédé selon la revendication 1, dans lequel le système de réseau de neurones artificiels est entraîné sur un

ensemble de vecteurs $\hat{Z}^j$ d'entraînement, chaque vecteur $\hat{Z}^j$ étant comparé avec la sortie du système de réseau de neurones artificiels lorsqu'elle est appliquée à un vecteur $\hat{X}^{j,T}$, avec $\hat{X}^j = (\hat{X}_1^{0,j}, ..., \hat{X}_{M_0}^{0,j})$, les vecteurs $\hat{X}^j$ étant obtenus par l'application, respectivement aux vecteurs $\hat{Z}^j$, successivement d'une première transformation représentant le codeur E et d'une seconde transformation représentant au moins :

- un schéma d'émission de l'émetteur, ledit schéma d'émission suivant le codeur E, et
- un canal de radiocommunication.

3. Procédé selon l'une quelconque des revendications précédentes, dans lequel lesdits paramètres $w_{1,m}^{i-1}, ..., w_{M_{i-1},m}^{i-1}, \beta_m^i$, avec m de 1 à $M_i$ et i de 1 à N sont calculés pour rendre minimale une distance entre respectivement des sorties $F(\hat{X}_1^{0,j}, ..., \hat{X}_{M_0}^{0,j})$ du décodeur et des vecteurs $\hat{Z}^j$ d'un ensemble de vecteurs d'entraînement, avec $\hat{Z}^j = (\hat{Z}_1^j, ..., \hat{Z}_{M_N}^j)$,

les vecteurs $\hat{X}^j$, avec $\hat{X}^j = (\hat{X}_1^{0,j}, ..., \hat{X}_{M_0}^{0,j})$, étant obtenus par l'application, respectivement aux vecteurs $\hat{Z}^j$, successivement d'une première transformation représentant le codeur E et d'une seconde transformation représentant au moins :

- un schéma d'émission de l'émetteur, ledit schéma d'émission suivant le codeur E, et
- un canal de communication sans fil.

4. Procédé selon l'une quelconque des revendications précédentes, dans lequel la fonction d'activation à niveaux multiples est définie comme :

$$f_{K,B_1,...,B_{K-1},A,\tau_1,\tau_{K-1}}(x) = \sum_{l=1}^{K-1} B_l f_l(x - \tau_l) + A$$

avec chaque $f_l$ étant une fonction d'activation,
avec $\tau_l$ étant des nombres réels, et si $l \neq l' \Rightarrow \tau_l \neq \tau_{l'}$,
avec A et les $B_l$ étant des nombres réels
et K un nombre entier positif supérieur ou égal à 3.

5. Procédé selon l'une quelconque des revendications précédentes, dans lequel des entrées du codeur E sont connectées à des sorties d'un codeur de modulation.

6. Procédé selon la revendication 5, dans lequel au moins l'une des fonctions $f_m^N$ avec m de 1 à $M_N$, est une fonction d'activation à niveaux multiples.

7. Procédé selon la revendication 6, dans lequel des symboles dans un type de modulation utilisé par le codeur de modulation sont chacun définis par P coordonnées ($q_1$ ; ... ; $q_P$), dans lequel au moins P' fonctions ( $f_{m_1}^N, ..., f_{m_{P'}}^N$ ) parmi les fonctions $f_m^N$, avec m de 1 à $M_N$, délivrent respectivement en sortie des valeurs de P' coordonnées parmi les P coordonnées ($q_1$ ; ... ; $q_P$) et dans lequel pour chaque k de 1 à P', $f_{m_k}^N$ étant une fonction d'activation à niveaux multiples de niveau $K_k$, où $K_k$ est égal au nombre de valeurs que peut prendre la k-ième coordonnée parmi les P' coordonnées des symboles du type de modulation.

8. Procédé selon l'une quelconque des revendications 1 à 7, dans lequel le codeur E comprend un codeur maillé, dans lequel les entrées du codeur maillé sont des entrées du codeur E.

9. Procédé selon l'une quelconque des revendications précédentes, dans lequel le codeur E comprend un codeur MIMO.

10. Produit programme d'ordinateur comprenant des instructions de code pour réaliser le procédé selon l'une quelconque des revendications 1 à 9, lorsque lesdites instructions sont exécutées par un processeur.

11. Dispositif pour la réception de $M_0$ symboles $X_1^0, \ldots, X_{M_0}^0$ en provenance d'un émetteur par le biais d'un support de communication sans fil, lesdits symboles reçus représentant des symboles codés par un codeur E de l'émetteur, le dispositif comprend :

- un module de réception ; et
- un décodeur, ledit décodeur comprenant un système de réseau de neurones artificiels ayant N couches ;
dans lequel le décodeur est défini comme une fonction F qui est définie par N ensembles de fonctions $F_1^i, \ldots, F_{M_i}^i$ avec i de 1 à N, dans lequel chaque fonction $F_m^i$ correspond à un neurone de la i-ème couche dudit système de réseau de neurones artificiels, dans lequel

$$F_m^i(X_1^{i-1}, \ldots, X_{M_{i-1}}^{i-1}) = f_m^i(\sum_{k=1}^{M_{i-1}} w_{k,m}^{i-1} \times X_k^{i-1} + \beta_m^i)$$, avec

$$F(X_1^0, \ldots, X_{M_0}^0) = \left[ F_1^N(X_1^{N-1}, \ldots, X_{M_{N-1}}^{N-1}), \ldots, F_{M_N}^N(X_1^{N-1}, \ldots, X_{M_{N-1}}^{N-1}) \right]$$, où, $X_m^{i-1}$ sont respectivement les sorties des fonctions $F_m^{i-1}$, $X_m^{i-1} = F_m^{i-1}(X_1^{i-2}, \ldots, X_{M_{i-1}}^{i-2})$ du (i-1)-ième ensemble, dans lequel chaque $f_m^i$ est soit une fonction d'activation de réseau de neurones artificiels, soit une fonction d'identité, et

$$w_{1,m}^{i-1}, \ldots, w_{M_{i-1},m}^{i-1}, \beta_m^i$$ pour m de 1 à $M_i$ et pour i de 1 à N sont des paramètres en nombre réel dudit réseau de neurones artificiels,

dans lequel au moins l'une des fonctions $f_m^i$ avec m de 1 à $M_i$ et i de 1 à N-1 est une fonction d'activation à niveaux multiples ;
dans lequel une fonction d'activation à niveaux multiples est une fonction d'activation qui permet de considérer strictement plus de deux niveaux de sortie.

FIG. 1

EP 3 648 012 B1

# FIG. 2

$$Vector\ Z_1 = (A; B; B; C)$$
$$Vector\ Z_2 = (A; A; B; C)$$

FIG. 3

EP 3 648 012 B1

FIG. 4

Hidden Layer 1

Hidden Layer 2

Input Layer

Output Layer

$$w_{1,1}^0$$

$$f_1^1$$

$$f_2^1$$

$$f_1^2$$

$$w_{2,1}^1$$

$$f_1^3$$

$$X_1^0$$

$$w_{2,2}^1$$

$$f_2^2$$

$$f_2^3$$

$$w_{3,2}^1$$

$$w_{M_0,1}^0$$

$$f_{M_1}^2$$

$$X_{M_0}^0$$

$$f_{M_0}^1$$

$$f_{M_2}^3$$

F

## FIG. 5

$Vector\ Z_1 = (A; B; B; C)$

$Vector\ Z_2 = (A; A; B; C)$

FIG. 6

$$Vector\ y_1 = 1e_1 + 6e_2 = (1,5;3)$$

$$Vector\ y_2 = 4e_1 + 5e_2 = (6;2,5)$$

FIG. 7

EP 3 648 012 B1

FIG. 8

```
┌─────────────────────┐
│      TRA_ANN        │────── S11
└─────────────────────┘
           │
           ▼
┌─────────────────────┐
│     PRO_PreANN      │────── S12
└─────────────────────┘
           │
           ▼
┌─────────────────────┐
│      PRO_ANN        │────── S13
└─────────────────────┘
           │
           ▼
┌─────────────────────┐
│    PRO_PostANN      │────── S14
└─────────────────────┘
```

# FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Neural-net based receiver structures for single- and multi-amplitude signals in interference channels. **BOURAS D P et al.** NEURAL NETWORKS FOR SIGNAL PROCESSING Y1994 IV. PROCEEDINGS OF THE 1994 IEEE WORKSHOP ERMIONI, GREECE 6-8 SEPT. 1, NEW YORK, NY, USA. IEEE, 06 September 1994, 535-544